# EUROPEAN PATENT APPLICATION

(11) **EP 4 635 762 A1**
(43) Date of publication of application: **22.10.2025**
(21) Application number: 25162073.8
(22) Date of filing: 06.03.2025
(51) Int. Cl.: B60H 1/00, B60H 1/32

(54) **HEAT MANAGEMENT SYSTEM AND VEHICLE**

(30) Priority: 21.03.2024 JP 2024045037
(71) Applicant: TOYOTA JIDOSHA KABUSHIKI KAISHA, Toyota-shi, Aichi-ken, 471-8571 (JP)
(72) Inventor: MIYOSHI, Yuji, Toyota-shi, 471-8571 (JP); KAWABE, Takayuki, Toyota-shi, 471-8571 (JP); IMAI, Sohichi, Toyota-shi, 471-8571 (JP)
(74) Representative: D Young & Co LLP

(57) **Abstract**

A heat management system includes: a first flow passage in which a reserve tank is not provided; a second flow passage in which a reserve tank (162) is provided; a switching device (180A) configured to switch between coupling and uncoupling of the first flow passage and the second flow passage to and from each other; and a control device configured to control the switching device. The control device is configured to, when predetermined coupling conditions are met, make the heat medium flow through the first flow passage and the second flow passage that have been coupled to each other by the switching device. When the control device determines that air bubbles exceeding the allowable volume are present in the heat medium, the coupling conditions switch from being unmet to being met.

## Description

### BACKGROUND OF THE INVENTION

### 1. Field of the Invention

This disclosure relates to a heat management system and a vehicle.

### 2. Description of Related Art

Japanese Unexamined Patent Application Publication No. 2023-063735 (JP 2023-063735 A) discloses a temperature control system including a coolant circuit. In this coolant circuit, first to fifth paths through which a coolant flows, a five-way valve, and a reserve tank are provided. Each of the first to fifth paths is connected at one end to the five-way valve and at the other end to the reserve tank. The five-way valve switches connection of cooling paths such that the coolant having been input from at least one of the third path and the fifth path is output to at least one of the first path, the second path, and the fourth path. A radiator is connected to the first path. The second path bypasses the radiator. A power control unit (PCU) and a water pump are connected to the third path. A battery is connected to the fourth path. A chiller and the water pump are connected to the fifth path.

### SUMMARY OF THE INVENTION

In the system described in JP 2023-063735 A, the first to fifth paths through which a heat medium, such as a coolant, flows are all connected to the reserve tank. However, depending on the structure of a vehicle, it may be difficult to connect all paths (flow passages) that are connectable by a switching device (e.g., a five-way valve) to a reserve tank. In a heat management system of such a vehicle, a plurality of flow passages that is connectable by a switching device sometimes includes a flow passage that is uncoupled from a reserve tank. The problem is that, in the flow passage uncoupled from the reserve tank, air bubbles tend to form or remain in a heat medium flowing through that flow passage. When the volume of air bubbles in the heat medium becomes large, deterioration and/or overspeed rotation of a pump that circulates the heat medium are likely to be promoted.

This disclosure provides a heat management system and a vehicle that can make a heat medium flow through a flow passage uncoupled from a reserve tank as necessary while reducing the volume of air bubbles in the heat medium.

According to an embodiment pursuant to a first aspect of this disclosure, a heat management system shown below is provided.

### Embodiment 1

The heat management system includes: a first flow passage in which a reserve tank is not provided; a second flow passage in which a reserve tank is provided; a switching device configured to switch between coupling and uncoupling of the first flow passage and the second flow passage to and from each other; and a control device configured to control the switching device. The control device is configured to, when predetermined coupling conditions are met, make the heat medium flow through the first flow passage and the second flow passage that have been coupled to each other by the switching device. The control device is configured to determine whether air bubbles exceeding an allowable volume are present in the heat medium. The heat management system is configured to, when the control device determines that air bubbles exceeding the allowable volume are present in the heat medium, switch the coupling conditions from being unmet to being met.

This heat management system includes the switching device that switches between coupling and uncoupling of the first flow passage and the second flow passage to and from each other, which helps perform appropriate heat management according to the situation. However, when the first flow passage is uncoupled from the reserve tank, air bubbles may form in the heat medium inside the first flow passage. Therefore, when the predetermined coupling conditions are met, the above-described control device makes the heat medium flow through the first flow passage and the second flow passage that have been coupled to each other. As the first flow passage is connected to the second flow passage in which the reserve tank is provided, air bleeding of the heat medium inside the first flow passage is performed. Moreover, the control device determines whether air bubbles exceeding the allowable volume are present in the heat medium. When the control device determines that air bubbles exceeding the allowable volume are present in the heat medium, the coupling conditions switch from being unmet to being met. This helps perform air bleeding of the heat medium with an appropriate frequency. Thus, this heat management system makes it possible to make a heat medium flow through a flow passage uncoupled from a reserve tank as necessary while reducing the volume of air bubbles in the heat medium.

The heat management system described in embodiment 1 can have a configuration described in any one of embodiment 2 to embodiment 9 shown below.

### Embodiment 2

The heat management system described in embodiment 1 may be configured to, when the coupling conditions are met, prohibit the switching device from uncoupling the first flow passage and the second flow passage from each other. The heat management system may be configured to, when the coupling conditions are not met, permit the switching device to uncouple the first flow passage and the second flow passage from each other.

According to this configuration, when the coupling conditions are met, the first flow passage and the second flow passage are maintained in a coupled state. This helps appropriately perform air bleeding of the heat medium. When the coupling conditions are not met, the first flow passage and the second flow passage can be uncoupled from each other. This helps appropriately perform heat management of the vehicle. When the coupling conditions are not met, the control device may switch between coupling and uncoupling of the first flow passage and the second flow passage to and from each other according to, for example, a state of the vehicle.

### Embodiment 3

The heat management system described in embodiment 1 or embodiment 2 may further include a pump that makes the heat medium flow through the first flow passage. The control device may be configured to detect overspeed rotation of the pump based on a state of the pump. The control device may be configured to determine that air bubbles exceeding the allowable volume are present in the heat medium when overspeed rotation of the pump is detected.

This configuration helps the control device accurately and easily determine whether air bubbles exceeding the allowable volume are present in the heat medium.

### Embodiment 4

The heat management system described in any one of embodiment 1 to embodiment 3 may further include a temperature sensor that detects a temperature of the heat medium. The control device may be configured to determine whether air bubbles exceeding the allowable volume are present in the heat medium based on whether or not a locus length of a detection value obtained by the temperature sensor is equal to or longer than a predetermined value.

This configuration helps the control device accurately and easily determine whether air bubbles exceeding the allowable volume are present in the heat medium.

### Embodiment 5

In the heat management system described in any one of embodiment 1 to embodiment 4, the control device may be configured to determine whether air bleeding of the heat medium has been completed during a period when the coupling conditions are met. When it is determined that the air bleeding of the heat medium has been completed, the heat management system may be configured to switch the coupling conditions from being met to being unmet.

According to this configuration, when the control device determines that air bubbles exceeding the allowable volume are present in the heat medium, air bleeding (coupling of the first flow passage and the second flow passage to each other) is executed. When the air bleeding of the heat medium has been completed, the first flow passage and the second flow passage can be uncoupled from each other. This helps appropriately perform heat management of the vehicle while reducing the volume of air bubbles in the heat medium.

### Embodiment 6

In the heat management system described in embodiment 5, the control device may be configured to determine that the air bleeding of the heat medium has been completed when a predetermined time has elapsed since the coupling conditions have been met.

According to this configuration, whether the air bleeding of the heat medium has been completed can be easily and appropriately determined.

### embodiment 7

In the heat management system described in embodiment 5, the control device may be configured to determine that the air bleeding of the heat medium has been completed when it is determined that air bubbles exceeding the allowable volume are not present in the heat medium.

According to this configuration, whether the air bleeding of the heat medium has been completed can be easily and appropriately determined.

### Embodiment 8

The heat management system described in any one of embodiment 1 to embodiment 4 may be configured to switch the coupling conditions from being met to being unmet when a predetermined time has elapsed since the coupling conditions have been met. The predetermined time may become shorter as a temperature of a heating element provided in the second flow passage becomes higher.

This configuration helps achieve both cooling of the heating element and air bleeding of the heat medium.

### Embodiment 9

In the heat management system described in any one of embodiment 1 to embodiment 8, the switching device may include one or more of a four-way valve, a five-way valve, a six-way valve, a seven-way valve, an eight-way valve, a nine-way valve, and a ten-way valve.

This switching device helps appropriately switch between coupling and uncoupling of the first flow passage and the second flow passage to and from each other.

According to an embodiment pursuant to a second aspect of this disclosure, a vehicle shown below is provided.

### Embodiment 10

This vehicle includes the heat management system described in any one of embodiment 1 to embodiment 9.

By the heat management system described earlier, this vehicle can make a heat medium flow through a flow passage uncoupled from a reserve tank as necessary while reducing the volume of air bubbles in the heat medium.

### Embodiment 11

In the vehicle described in embodiment 10, the first flow passage may be configured to cool a first heating element installed in the vehicle by the heat medium. The second flow passage may include a cooling path configured to cool a second heating element installed in the vehicle by the heat medium, and a bypass path configured to bypass the second heating element. The switching device may be configured to switch between the cooling path and the bypass path.

This configuration helps appropriately perform heat management of each of the first heating element and the second heating element that are installed in the vehicle.

### Embodiment 12

In the vehicle described in embodiment 11, the second heating element may include an electricity storage device. The first heating element may include a component configured to receive a supply of electricity from the electricity storage device. The control device may be configured to, when the coupling conditions are met and, moreover, a temperature of the heat medium inside the first flow passage is lower than a predetermined temperature, couple the first flow passage and the cooling path of the second flow passage to each other by the switching device and make the heat medium flow through the first flow passage and the cooling path. The control device may be configured to, when the coupling conditions are met and, moreover, the temperature of the heat medium inside the first flow passage exceeds the predetermined temperature, couple the first flow passage and the bypass path of the second flow passage to each other by the switching device and make the heat medium flow through the first flow passage and the bypass path.

An on-board component that receives a supply of electricity from the electricity storage device tends to heat up and can raise the temperature of the heat medium inside the first flow passage. If the temperature of the heat medium inside the first flow passage rises excessively, when the first flow passage and the second flow passage are coupled to each other, it is difficult to cool the electricity storage device by the heat medium and it is even possible that the heat medium may conversely raise the temperature of the electricity storage device. In the above-described configuration, therefore, the cooling path and the bypass path are switched according to the temperature of the heat medium inside the first flow passage. This helps appropriately perform heat management of the electricity storage device.

This disclosure can provide a heat management system and a vehicle that can make a heat medium flow through a flow passage uncoupled from a reserve tank as necessary while reducing the volume of air bubbles in the heat medium.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a view showing the configuration of a heat management system according to a first embodiment of this disclosure;
FIG. 2 is a view showing one example of the configuration of a heat management circuit according to the first embodiment;
FIG. 3 is a view showing a vehicle to which the heat management system according to the first embodiment is applied;
FIG. 4 is a view showing an uncoupling mode of the heat management system according to the first embodiment;
FIG. 5 is a view showing a first coupling mode of the heat management system according to the first embodiment;
FIG. 6 is a view showing a second coupling mode of the heat management system according to the first embodiment;
FIG. 7 is a flowchart showing air bleeding control in the first embodiment;
FIG. 8 is a view for describing a first air bubble determination method;
FIG. 9 is a view for describing a second air bubble determination method;
FIG. 10 is a flowchart showing a modified example of the control shown in FIG. 7;
FIG. 11 is a view for describing a modified example of a setting method of a threshold value that is used for air-bleeding ending determination;
FIG. 12 is a view showing the configuration of a heat management system according to a second embodiment;
FIG. 13 is a view showing an uncoupling mode of the heat management system according to the second embodiment;
FIG. 14 is a view showing a coupling mode of the heat management system according to the second embodiment;
FIG. 15 is a flowchart showing air bleeding control in the second embodiment;
FIG. 16 is a flowchart showing a modified example of the control shown in FIG. 15;
FIG. 17 is a view showing a first modified example of the configuration of the heat management system shown in FIG. 1;
FIG. 18 is a view showing an uncoupling mode of the heat management system shown in FIG. 17;
FIG. 19 is a view showing a first coupling mode of the heat management system shown in FIG. 17;
FIG. 20 is a view showing a second coupling mode of the heat management system shown in FIG. 17;
FIG. 21 is a view showing a third coupling mode of the heat management system shown in FIG. 17;
FIG. 22 is a view showing a second modified example of the configuration of the heat management system shown in FIG. 1 in the state of the uncoupling mode;
FIG. 23 is a view showing a first coupling mode of the heat management system shown in FIG. 22;
FIG. 24 is a view showing a second coupling mode of the heat management system shown in FIG. 22; and
FIG. 25 is a view showing a third coupling mode of the heat management system shown in FIG. 22.

### DETAILED DESCRIPTION OF EMBODIMENTS

Embodiments of this disclosure will be described in detail with reference to the drawings. In the drawings, the same or equivalent parts will be denoted by the same reference signs and description thereof will not be repeated.

### First Embodiment

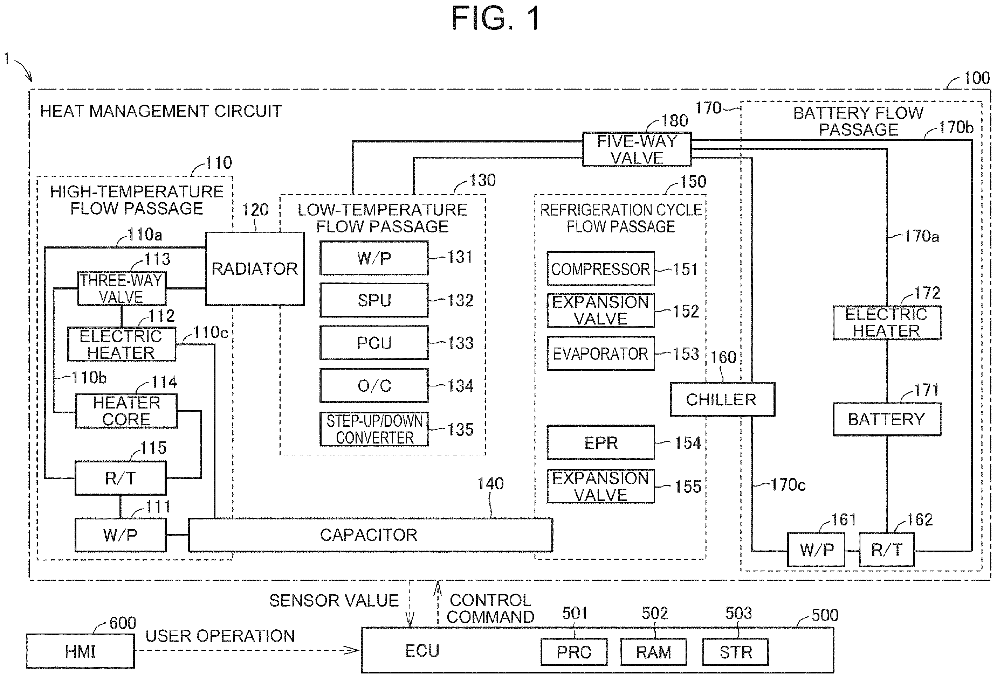

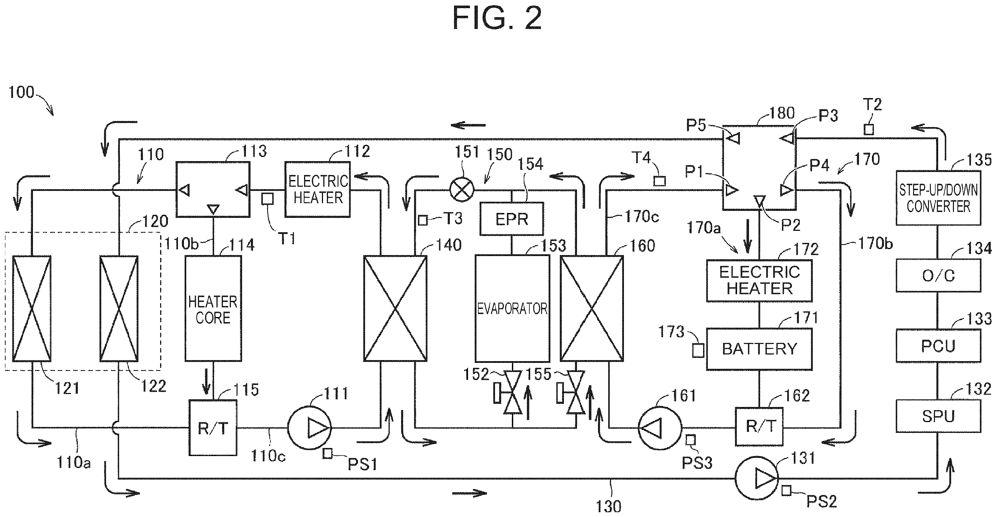

FIG. 1 is a view showing the overall configuration of a heat management system according to a first embodiment. FIG. 2 is a view showing the configuration of a heat management circuit according to the first embodiment. As shown in FIG. 1, a heat management system 1 includes a heat management circuit 100, an electronic control unit (ECU) 500, and a human-machine interface (HMI) 600.

Referring to FIG. 2 along with FIG. 1, the heat management circuit 100 includes a high-temperature flow passage 110, a radiator 120, a low-temperature flow passage 130, a capacitor 140, a refrigeration cycle flow passage 150, a chiller 160, a battery flow passage 170, and a five-way valve 180.

The high-temperature flow passage 110 and the refrigeration cycle flow passage 150 are separated from each other and do not communicate with each other. The high-temperature flow passage 110 and the low-temperature flow passage 130 are also separated from each other and do not communicate with each other. However, the high-temperature flow passage 110 and the refrigeration cycle flow passage 150 are connected to each other through the capacitor 140 so as to be able to exchange heat. The capacitor 140 is connected to both the high-temperature flow passage 110 and the refrigeration cycle flow passage 150. The high-temperature flow passage 110 and the low-temperature flow passage 130 are connected to each other through the radiator 120 so as to be able to exchange heat. The radiator 120 is connected to both the high-temperature flow passage 110 and the low-temperature flow passage 130. As shown in FIG. 2, the radiator 120 includes a high-temperature (HT) radiator 121 and a low-temperature (LT) radiator 122.

The refrigeration cycle flow passage 150 and the battery flow passage 170 are separated from each other and do not communicate with each other. However, the refrigeration cycle flow passage 150 and the battery flow passage 170 are connected to each other through the chiller 160 so as to be able to exchange heat. The chiller 160 is connected to both the refrigeration cycle flow passage 150 and the battery flow passage 170.

The five-way valve 180 includes five ports P1 to P5. The five-way valve 180 is configured to be able to switch between coupling (communication) and uncoupling (no communication) of the low-temperature flow passage 130 and the battery flow passage 170 to and from each other. In the low-temperature flow passage 130, no reserve tank (R/T) is provided. In the battery flow passage 170, a reserve tank 162 is provided. The five-way valve 180 is controlled by the ECU 500. The five-way valve 180, the low-temperature flow passage 130, the battery flow passage 170, and the ECU 500 correspond to one example of "switching device," "first flow passage," "second flow passage," and "control device," respectively, according to this disclosure.

The high-temperature flow passage 110 includes flow passages 110a, 110b, 110c. In the high-temperature flow passage 110, a three-way valve 113 and a reserve tank 115 are provided. Each of the flow passages 110a, 110b, 110c is connected at one end to the three-way valve 113 and at the other end to the reserve tank 115. In the flow passage 110a, a high-temperature radiator 121 is provided. In the flow passage 110b, a heater core 114 is provided. In the flow passage 110c, a pump 111, an electric heater 112, and a capacitor 140 are provided.

One end of the low-temperature flow passage 130 is connected to the port P3 of the five-way valve 180, and the other end of the low-temperature flow passage 130 is connected to the port P5 of the five-way valve 180. In the low-temperature flow passage 130, a pump 131, a smart power unit (SPU) 132, a power control unit (PCU) 133, an oil cooler (O/C) 134, and a step-up/down converter 135 are provided.

In the refrigeration cycle flow passage 150, various devices that perform temperature adjustment by a refrigeration cycle (i.e., a cycle consisting of an evaporation process, a compression process, a condensation process, and an expansion process) are provided. Specifically, in the refrigeration cycle flow passage 150, a compressor 151, an expansion valve 152, an evaporator 153, an evaporative pressure regulator (EPR) 154, and an expansion valve 155 are provided.

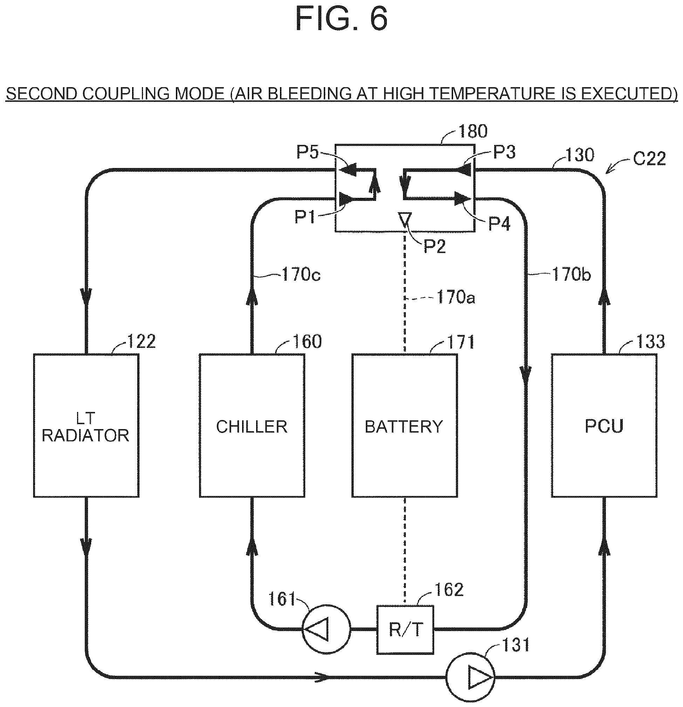

The battery flow passage 170 includes flow passages 170a, 170b, 170c. Each of the flow passages 170a, 170b, 170c is connected at one end to the five-way valve 180 and at the other end to the reserve tank 162. Specifically, the flow passages 170a, 170b, 170c are connected at one end to the ports P2, P4, P1, respectively, of the five-way valve 180. In the flow passage 170a, a battery 171 and an electric heater 172 are provided. The electric heater 172 heats at least one of a heat medium inside the flow passage 170a and the battery 171. In the flow passage 170c, a pump 161 is provided. The flow passage 170b is provided so as to make a detour around the flow passage 170a. The five-way valve 180 is configured to be able to switch between the flow passage 170a and the flow passage 170b. When the flow passage 170b has been connected to the low-temperature flow passage 130 by the five-way valve 180, a heat medium flowing from the low-temperature flow passage 130 into the five-way valve 180 flows to the reserve tank 162 so as to avoid the flow passage 170a (including the battery 171) (see FIG. 6 to be described later). In this embodiment, the flow passage 170a functions as a cooling path that can cool the battery 171 by the heat medium. The flow passage 170b functions as a bypass path that bypasses the battery 171.

A first heat medium flows through the high-temperature flow passage 110. A second heat medium flows through the refrigeration cycle flow passage 150. A third heat medium flows through each of the low-temperature flow passage 130 and the battery flow passage 170. In this embodiment, the heat medium (third heat medium) of the same type as the heat medium flowing through the low-temperature flow passage 130 flows through the battery flow passage 170. As each of the first to third heat media, a commonly known heat medium can be adopted. Examples of the second heat medium include a hydrofluorocarbon-based refrigerant, such as R-134a, a hydrofluoroolefin-based refrigerant, such as R-1234yf, a carbon dioxide gas (CO₂), such as R744, and a propane gas. In this embodiment, as each of the first heat medium and the third heat medium, a liquid heat medium (e.g., water or a coolant other than water) is adopted. Examples of coolants other than water include insulating oil and an antifreeze solution, such as a long life coolant (LLC). In this embodiment, each of the pumps 111, 131, 161 is a water pump (W/P). The ECU 500 executes pulse width modulation (PWM) control of each pump using a pump driving signal. The pump driving signal indicates a duty ratio (a ratio of a high-level period relative to a cycle) relating to a driving order (high-level and low-level driving signals) for the pump.

As shown in FIG. 2, in the pumps 111, 131, 161, pump sensors PS1, PS2, PS3, respectively, are provided. Each of the pump sensors PS1 to PS3 is configured to detect the state (e.g., the rotation speed, the current, and the temperature) of the corresponding pump. In the high-temperature flow passage 110, the low-temperature flow passage 130, the refrigeration cycle flow passage 150, and the battery flow passage 170, flow passage sensors T1, T2, T3, T4, respectively, are provided. Each of the flow passage sensors T1 to T4 includes a temperature sensor that detects the temperature of the heat medium inside the corresponding flow passage, and a flow rate sensor that measures the flow rate of the heat medium flowing through the corresponding flow passage. In the battery 171, a battery management system (BMS) 173 that monitors the state of the battery 171 is provided. The BMS 173 includes various sensors that detect the state of the battery 171 (e.g., the voltage, the current, and the temperature) and output the detection results to the ECU 500. In addition to this sensor function, the BMS 173 may further have at least one of a state-of-charge (SOC) estimation function and a state-of-health (SOH) estimation function.

The ECU 500 acquires detection results (sensor values) from various sensors included in the heat management circuit 100 and controls various devices included in the heat management circuit 100. The ECU 500 includes a processor 501, a random-access memory (RAM) 502, and a storage device 503. Examples of the processor 501 include a central processing unit (CPU). The number of processors included in the ECU 500 may be one, or may be two or more. The storage device 503 is configured to be able to retain information contained therein. The storage device 503 may include at least one of a hard disk drive (HDD), a solid-state drive (SSD), and a non-volatile memory. The ECU 500 has a time measuring function (timer). This time measuring function may be realized by hardware (timer circuit) or may be realized by software.

In the storage device 503 of the ECU 500, other than programs, various types of information used in the programs are stored. In this embodiment, various types of control are executed as the processor 501 executes the programs stored in the storage device 503. However, these processes may be executed by hardware (e.g., a logic circuit, such as a wired logic) alone without using software.

The human-machine interface (HMI) 600 functions as an interface between a user and the ECU 500. The HMI 600 includes an input device and a notification device. The input device receives user operation. The notification device notifies user by display or sound (including voice). The HMI 600 may be an on-board HMI or may be a mobile terminal that the user can carry.

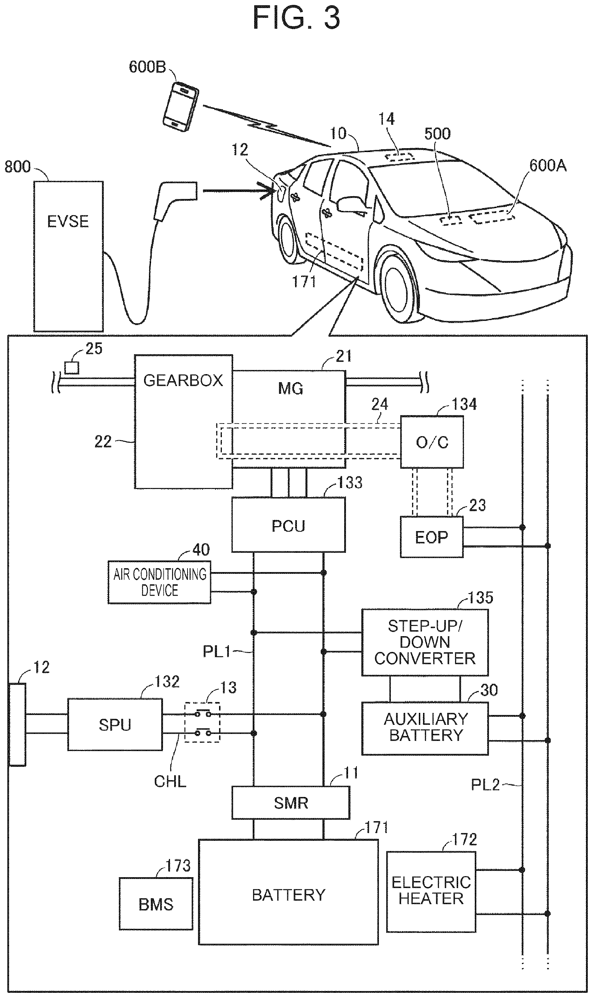

FIG. 3 is a view showing one example of the configuration of a vehicle equipped with the heat management system according to the first embodiment. Referring to FIG. 1 to FIG. 3, the vehicle 10 is an electrified vehicle (xEV) equipped with the heat management circuit 100 and the ECU 500 described above. The vehicle 10 is configured to be able to travel using electricity output from the battery 171 (driving battery). The battery 171 may include, for example, a secondary battery, such as a lithium-ion battery, a nickel-metal hydride battery, or a sodium ion battery. The type of the secondary battery may be a liquid secondary battery or an all-solid-state secondary battery. A plurality of secondary batteries may form a battery pack. Instead of a secondary battery, other electricity storage device (e.g., an electric double-layer capacitor) may be adopted. The vehicle 10 is, for example, a battery electric vehicle (BEV) that does not include an internal combustion engine. However, without being limited thereto, the vehicle 10 may be a plug-in hybrid electric vehicle (PHEV) including an internal combustion engine or may be other electrified vehicle (xEV).

The vehicle 10 further includes a system main relay (SMR) 11, an inlet 12, a charging relay 13, a communication device 14, a motor generator (MG) 21, a gearbox 22, an electric oil pump (EOP) 23, an oil circuit 24, a wheel speed sensor 25, an auxiliary battery 30, and an air conditioning device 40. The voltage of the battery 171 is higher than the voltage of the auxiliary battery 30. The battery 171 applies a voltage to a high-voltage power source line PL1. The auxiliary battery 30 is a low-voltage power source for auxiliaries and applies a voltage to a low-voltage power source line PL2. The air conditioning device 40 is connected to the high-voltage power source line PL1 and receives a supply of electricity from the battery 171. In the vehicle 10, a heating circuit of the air conditioning device 40 constitutes the high-temperature flow passage 110 (FIG. 2), and a cooling circuit of the air conditioning device 40 constitutes the refrigeration cycle flow passage 150 (FIG. 2). The SMR 11, the charging relay 13, the EOP 23, the air conditioning device 40, the PCU 133, the step-up/down converter 135, and the electric heater 172 are controlled by the ECU 500.

The SMR 11 is a relay located between the battery 171 and the PCU 133. The MG 21 functions as a driving motor and rotates driving wheels of the vehicle 10. The PCU 133 is connected to the high-voltage power source line PL1 and drives the MG 21 using electricity supplied from the battery 171. The PCU 133 includes, for example, an inverter. The gearbox 22 includes, for example, a speed reducer and a differential gear device. The MG 21 converts electricity into torque. This torque is transmitted to the driving wheels of the vehicle 10 through the gearbox 22. The MG 21 performs regenerative power generation, for example, during deceleration of the vehicle 10, and charges the battery 171.

The wheel speed sensor 25 is provided on a wheel of the vehicle 10 or on an axle that rotates in conjunction with the wheel, and detects a rotation speed of the wheel. The wheel speed sensor 25 may be provided for each wheel. The wheel speed sensor 25 outputs a detection result to the ECU 500. The ECU 500 calculates a traveling speed (vehicle speed) of the vehicle 10 based on the detection signal of the wheel speed sensor 25.

The EOP 23 circulates lubricating oil through the oil circuit 24. The oil cooler 134 is connected to both the low-temperature flow passage 130 and the oil circuit 24 and functions as a heat exchanger. The oil cooler 134 cools the lubricating oil inside the oil circuit 24 using the heat medium flowing through the low-temperature flow passage 130. The oil circuit 24 supplies the lubricating oil to the MG 21 and the gearbox 22 and cools the MG 21 and the gearbox 22 by the lubricating oil. However, without being limited thereto, the method of cooling the periphery of the motor can be changed as appropriate. For example, one of the MG 21 and the gearbox 22 may be oil-cooled by the oil circuit 24 and the other may be water-cooled by the low-temperature flow passage 130.

The step-up/down converter 135 is connected to the high-voltage power source line PL1 and performs conversion of the voltage of direct-current electricity between the battery 171 and the auxiliary battery 30. The step-up/down converter 135 includes a DC-DC converter. The step-up/down converter 135 steps down the direct-current electricity from the battery 171 and outputs the resulting electricity to the auxiliary battery 30. The auxiliary battery 30 supplies the electricity to on-board devices (a pump, a compressor, a heater, a valve, an ECU, etc.) connected to the low-voltage power source line PL2.

The vehicle 10 is configured to allow execution of external charging (charging of the battery 171 with electricity from outside the vehicle). The SPU 132 is provided in a charging line CHL and functions as an on-board charger (charging circuit). The SPU 132 may function as an electric supply unit (ESU). The charging relay 13 switches between connection and disconnection of the charging line CHL. The ECU 500 puts the charging relay 13 in a connected state before external charging is started, and controls the SPU 132 during the execution of the external charging. When a leading end portion (connector) of a charging cable leading to electric vehicle supply equipment (EVSE) 800 is connected to the inlet 12 of the vehicle 10 in a parked state (plug-in), the vehicle 10 is electrically connected to the EVSE 800. The battery 171 of the vehicle 10 can be charged using electricity input from the EVSE 800 to the inlet 12. In the example shown in FIG. 3, the charging line CHL is connected at one end to a point between the SMR 11 and the PCU 133 and at the other end to the inlet 12. However, without being limited thereto, the one end of the charging line CHL may be connected to a point between the battery 171 and the SMR 11.

The plurality of on-board devices shown in FIG. 3 may be integrated as an electric axle (eAxle) having an "Xin1" structure. Examples of "Xin1" structures include a "3in1" structure incorporating a driving motor, an inverter, and a gearbox, a "6in1" structure additionally incorporating a DC-DC converter, an on-board charger, and a BMS, and an "8in1" structure additionally incorporating a power distribution unit (PDU) and an ECU. An electric axle may be provided in each of a front and a rear of the vehicle 10. The low-temperature flow passage 130 may be configured to be able to cool these electric axles.

In the vehicle 10, the PCU 133 is cooled by the heat medium flowing through the low-temperature flow passage 130. The lubricating oil inside the oil circuit 24 is cooled by the heat medium flowing through the low-temperature flow passage 130, and the MG 21 is cooled by this lubricating oil. Thus, the low-temperature flow passage 130 is configured to be able to cool the MG 21 and the PCU 133 by the heat medium. The cooling path (flow passage 170a) of the battery flow passage 170 is configured to be able to cool the battery 171 by the heat medium. The battery 171 is an electricity storage device that stores electricity for making the vehicle 10 travel, and corresponds to one example of "second heating element" according to this disclosure. Each of the MG 21 and the PCU 133 is an on-board component that receives a supply of electricity from the battery 171 and corresponds to one example of "first heating element" according to this disclosure.

An HMI 600A is an HMI (on-board HMI) installed in the vehicle 10 and can function as the HMI 600 shown in FIG. 1. The HMI 600A may include at least one of a meter panel, a navigation system, a center display, and a head-up display. The HMI 600A may further include a smart speaker that receives a voice input or may include a display device that performs augmented reality (AR) display.

A mobile terminal 600B is a terminal carried by the user of the vehicle 10 and can function as the HMI 600 shown in FIG. 1. The ECU 500 performs wireless communication with the mobile terminal 600B through the communication device 14. The mobile terminal 600B is, for example, a smartphone equipped with a touch panel display. However, the mobile terminal 600B is not limited thereto, and a laptop, a portable game machine, a wearable device (e.g., a smartwatch, smart glasses, and a smart garment), an electronic key, etc. can also be adopted as the mobile terminal 600B.

In this embodiment, the heat management system 1 is configured to perform heat management of the vehicle 10 using the heat medium. In particular, the heat management system 1 can operate in a plurality of types of modes including an uncoupling mode, a first coupling mode, and a second coupling mode to be described below.

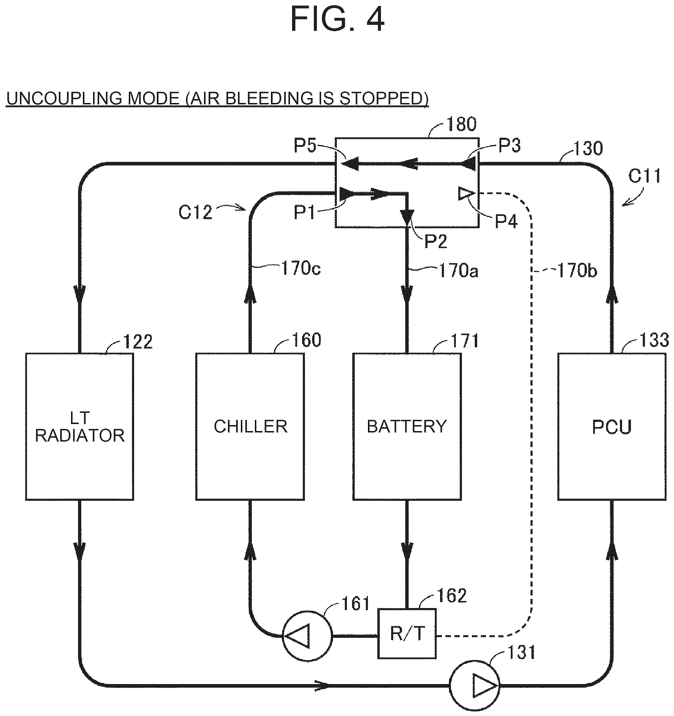

FIG. 4 is a view for describing the uncoupling mode of the heat management system 1. Referring to FIG. 4, in the uncoupling mode, in the five-way valve 180, the port P1 and the port P2 are connected to each other and the port P3 and the port P5 are connected to each other. The port P4 is not connected to any other port. Thus, circuits C11 and C12 that are uncoupled from each other are formed. The circuit C11 is a fluid circuit in which the port P5, the low-temperature flow passage 130, and the port P3 are sequentially connected to one another. In the uncoupling mode, the pump 131 is driven and the pump 131 circulates the heat medium through the circuit C11. Thus, the heat medium having flowed from the low-temperature flow passage 130 into the port P3 is output from the port P5 to the low-temperature flow passage 130. The circuit C12 is a fluid circuit in which the port P2, the flow passage 170a, the reserve tank 162, the flow passage 170c, and the port P1 are sequentially connected to one another. In the uncoupling mode, the pump 161 is also driven and the pump 161 circulates heat medium through the circuit C12. Thus, the heat medium having flowed from the flow passage 170c into the port P1 is output from the port P2 to the flow passage 170a. In the uncoupling mode, the circuit C11 (including the low-temperature flow passage 130) is uncoupled from the reserve tank. Therefore, air bleeding of the heat medium (third heat medium) inside the low-temperature flow passage 130 is not performed.

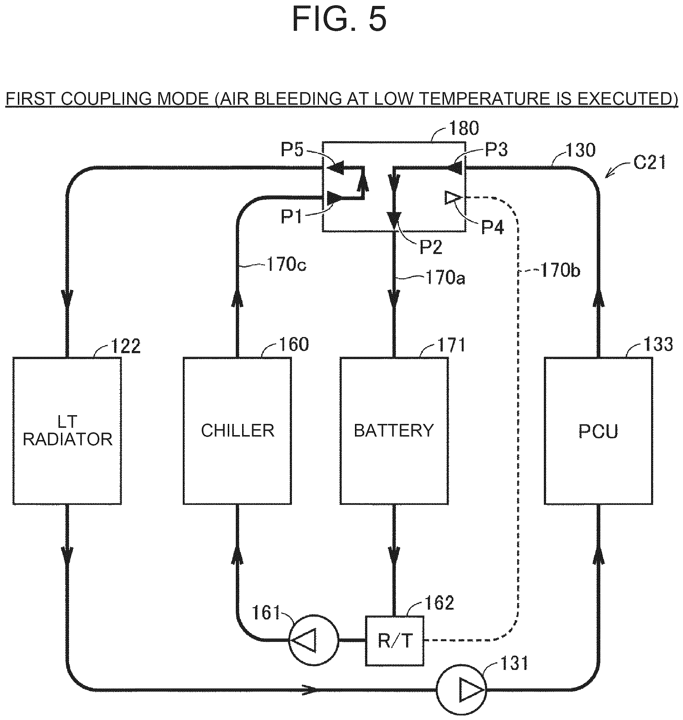

FIG. 5 is a view for describing the first coupling mode of the heat management system 1. Referring to FIG. 5, in the first coupling mode, in the five-way valve 180, the port P1 and the port P5 are connected to each other and the port P2 and the port P3 are connected to each other. The port P4 is not connected to any other port. Thus, a circuit C21 is formed. The circuit C21 is a fluid circuit in which the port P5, the low-temperature flow passage 130, the port P3, the port P2, the flow passage 170a, the reserve tank 162, the flow passage 170c, and the port P1 are sequentially connected to one another. In the first coupling mode, the pumps 131 and 161 are driven to circulate the heat medium through the circuit C21. Thus, the heat medium having flowed from the low-temperature flow passage 130 into the port P3 is output from the port P2 to the flow passage 170a and flows into the port P1 through the flow passage 170a, the reserve tank 162, and the flow passage 170c. Further, the heat medium having flowed into the port P1 is output from the port P5 to the low-temperature flow passage 130. In the first coupling mode, the cooling path (flow passage 170a) of the battery flow passage 170 and the low-temperature flow passage 130 are coupled to each other by the five-way valve 180. As the low-temperature flow passage 130 is connected to the battery flow passage 170 in which the reserve tank 162 is provided, air bleeding of the heat medium (third heat medium) inside the low-temperature flow passage 130 is performed. The ECU 500 may stop the pump 161 in the first coupling mode.

FIG. 6 is a view for describing the second coupling mode of the heat management system 1. Referring to FIG. 6, in the second coupling mode, in the five-way valve 180, the port P1 and the port P5 are connected to each other and the port P3 and the port P4 are connected to each other. The port P2 is not connected to any other port. Thus, a circuit C22 is formed. The circuit C22 is a fluid circuit in which the port P5, the low-temperature flow passage 130, the port P3, the port P4, the flow passage 170b, the reserve tank 162, the flow passage 170c, and the port P1 are sequentially connected to one another. In the second coupling mode, the pumps 131 and 161 are driven to circulate the heat medium through the circuit C22. Thus, the heat medium having flowed from the low-temperature flow passage 130 into the port P3 is output from the port P4 to the flow passage 170b and flows into the port P1 through the flow passage 170b, the reserve tank 162, and the flow passage 170c. Further, the heat medium having flowed into the port P1 is output from the port P5 to the low-temperature flow passage 130. In the second coupling mode, the bypass path (flow passage 170b) of the battery flow passage 170 and the low-temperature flow passage 130 are coupled to each other by the five-way valve 180. As the low-temperature flow passage 130 is connected to the battery flow passage 170 in which the reserve tank 162 is provided, air bleeding of the heat medium (third heat medium) inside the low-temperature flow passage 130 is performed. The ECU 500 may stop the pump 161 in the second coupling mode.

The ECU 500 switches among the uncoupling mode, the first coupling mode, and the second coupling mode by controlling the five-way valve 180. When the low-temperature flow passage 130 and the battery flow passage 170 have been uncoupled from each other by the five-way valve 180 (uncoupling mode), the ECU 500 makes the heat medium flow through the low-temperature flow passage 130 by the pump 131 provided in the low-temperature flow passage 130, and makes the heat medium flow through the battery flow passage 170 by the pump 161 provided in the battery flow passage 170 (see FIG. 4). When the low-temperature flow passage 130 and the battery flow passage 170 have been coupled to each other by the five-way valve 180 (first or second coupling mode), the ECU 500 makes the heat medium flow through the low-temperature flow passage 130 and the battery flow passage 170 by the pumps 131, 161 (see FIG. 5 and FIG. 6). This configuration helps appropriately make the heat medium flow through each of the low-temperature flow passage 130 and the battery flow passage 170 in any of the uncoupling mode, the first coupling mode, and the second coupling mode. Instead of the five-way valve 180, other multi-way valve (e.g., a six-way valve, a seven-way valve, an eight-way valve, a nine-way valve, or a ten-way valve) may be adopted as the switching device. The switching device may be composed of a plurality of multi-way valves.

In the vehicle 10, the heat medium (third heat medium) flowing through the low-temperature flow passage 130 and the battery flow passage 170 is replaced as necessary. The third heat medium may be replaced, for example, at a timing when a predetermined period (e.g., 15 years to 20 years) has elapsed from an initial state (new car). Or when an on-board component (e.g., the SPU 132) provided in the low-temperature flow passage 130 is replaced, the third heat medium may be replaced along with that component. For example, at a dealership or a factory, a worker removes a third heat medium before replacement from the vehicle 10 and pours a third heat medium after replacement into the vehicle 10. Thus, change from the third heat medium before replacement to the third heat medium after replacement is performed. In the new third heat medium having been poured (third heat medium after replacement), fine air bubbles remain and tend to gather into masses during travel of the vehicle 10. An air accumulation in the heat medium can cause degradation of the cooling performance of the heat medium. A large air accumulation in the heat medium can cause deterioration and/or overspeed rotation of a pump that circulates that heat medium.

As a countermeasure, in the vehicle 10, the ECU 500 is configured to, when predetermined coupling conditions are met, make the heat medium (third heat medium) flow through the low-temperature flow passage 130 and the battery flow passage 170 that have been coupled to each other by the five-way valve 180. In particular, when the coupling conditions are met, the ECU 500 makes the heat management system 1 operate in the first coupling mode (FIG. 5) or the second coupling mode (FIG. 6). As will be described in detail later, the ECU 500 determines whether air bubbles exceeding an allowable volume are present in the heat medium (third heat medium). When the ECU 500 determines that air bubbles exceeding the allowable volume are present in the heat medium, the coupling conditions switch from being unmet to being met. This helps perform air bleeding of the heat medium with an appropriate frequency. Specifically, when the ECU 500 has not detected inclusion of air bubbles into the heat medium (i.e., that air bubbles exceeding the allowable volume are present in the heat medium), the coupling conditions are not met, and the heat management system 1 can uncouple the low-temperature flow passage 130 and the battery flow passage 170 from each other by the five-way valve 180. The ECU 500 may make the heat management system 1 operate in the uncoupling mode (FIG. 4). Thus, heat management of the vehicle 10 can be performed separately by the low-temperature flow passage 130 and the battery flow passage 170. On the other hand, when the aforementioned coupling conditions are met, the low-temperature flow passage 130 is connected to the battery flow passage 170 in which the reserve tank is provided. Thus, air bleeding of the heat medium inside the low-temperature flow passage 130 (air bleeding by the reserve tank) is performed. This heat management system 1 makes it possible to make a heat medium flow through a flow passage (e.g., the circuit C11) uncoupled from a reserve tank as necessary while reducing the volume of air bubbles in the heat medium.

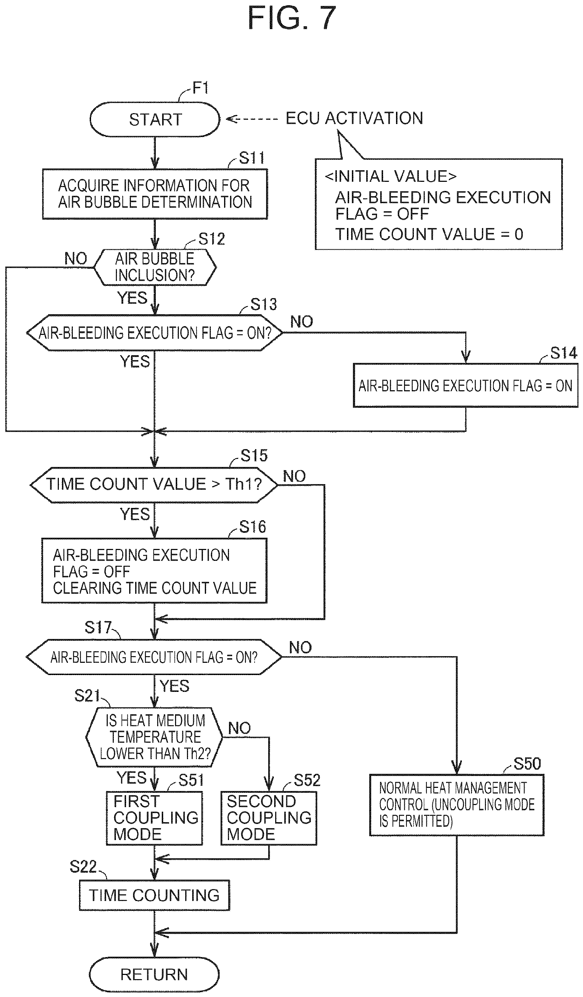

FIG. 7 is a flowchart showing air bleeding control and heat management control in the first embodiment. The letter "S" in the flowchart means a step. In this embodiment, an input device of the HMI 600A receives a system activation order and a system stop order from the user. When the input device receives the system activation order while the vehicle system (including the ECU 500) is in a stopped state, the ECU 500 is activated and starts the process flow F1 shown in FIG. 7. While the ECU 500 is in an operating state, the process flow F1 is repeatedly executed. An arithmetic operation cycle may be about 50 milliseconds. Thereafter, when the input device receives the system stop order, the ECU 500 executes a predetermined shutdown process and then enters the stopped state. With that, the process flow F1 ends.

In the process flow F1, an air-bleeding execution flag and a time count value are used. The air-bleeding execution flag is a parameter indicating whether the coupling conditions are met. That the air-bleeding execution flag is ON means that the coupling conditions are met. While the coupling conditions are met, the heat management system 1 operate in an air bleeding mode. In the air bleeding mode, the ECU 500 executes the air bleeding control that maintains the heat management system 1 in the coupling mode (the first or second coupling mode). The time count value is a parameter indicating a time that has elapsed since the air bleeding control was started. These parameters are stored in the storage device 503.

At the time of activation of the ECU 500, each of the above-described parameters has an initial value and the coupling conditions are not met. The initial value of the air-bleeding execution flag is "OFF," and the initial value of the time count value is "0." In this embodiment, when the ECU 500 determines that air bubbles exceeding the allowable volume are present in the heat medium, the coupling conditions switch from being unmet to being met. When the time count value exceeds a predetermined value, the coupling conditions switch from being met to being unmet. Hereinafter, determining whether air bubbles exceeding the allowable volume are present in the heat medium will be referred to as "air bubble determination."

Referring to FIG. 7, in S11, the ECU 500 acquires information for the air bubble determination (hereinafter referred to as "determination information") about the heat medium (third heat medium) inside the low-temperature flow passage 130. In the subsequent S12, using the acquired determination information, the ECU 500 determines whether air bubbles exceeding the allowable volume are present in the heat medium inside the low-temperature flow passage 130. Hereinafter, that air bubbles exceeding the allowable volume are present in the heat medium will be referred to as "air bubble inclusion," and that the volume of air bubbles in the heat medium does not exceed the allowable volume will be referred to as "no air bubble inclusion."

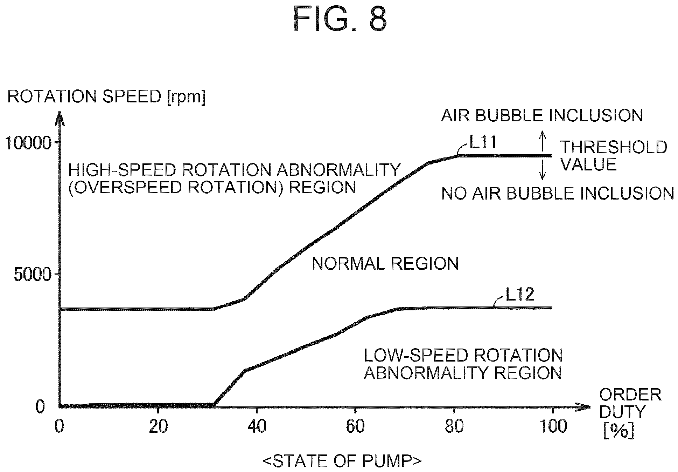

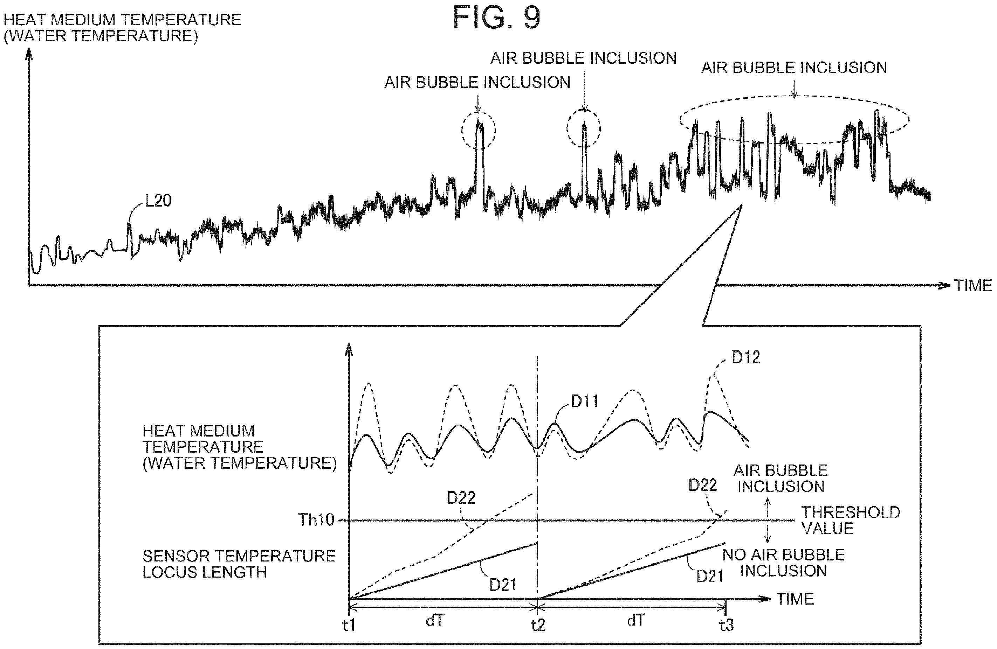

In this embodiment, the aforementioned determination information includes at least one of the state (e.g., the rotation speed) of the pump 131 shown in FIG. 8 and a locus length of a temperature detection value obtained by the flow passage sensor T2 (FIG. 2) shown in FIG. 9 (hereinafter referred to as "sensor temperature locus length").

FIG. 8 is a view for describing a first air bubble determination method. In FIG. 8, the axis of abscissa shows a duty ratio (order duty) of the pump driving signal that the pump 131 receives from the ECU 500, and the axis of ordinate shows the rotation speed of the pump 131. The pump 131 is driven in all of the uncoupling mode, the first coupling mode, and the second coupling mode to make the heat medium (third heat medium) flow through the low-temperature flow passage 130. The pump 131 is driven by the pump driving signal from the ECU 500. The rotation speed of the pump 131 is detected by the pump sensor PS2 (FIG. 2).

The line L11 represents a boundary value (first boundary value) between a high-speed rotation abnormality region and a normal region relating to the rotation speed (rpm) of the pump 131. There is a tendency that the first boundary value becomes higher as the order duty (%) becomes higher. The line L12 represents a boundary value (second boundary value) between the normal region and a low-speed rotation abnormality region relating to the rotation speed (rpm) of the pump 131. There is a tendency that the second boundary value becomes higher as the order duty (%) becomes higher. A region where the rotation speed of the pump 131 is equal to or higher than the second boundary value (line L12) and equal to or lower than the first boundary value (line L11) corresponds to the normal region. A region where the rotation speed of the pump 131 is higher than the first boundary value corresponds to the high-speed rotation abnormality region. A region where the rotation speed of the pump 131 is lower than the second boundary value corresponds to the low-speed rotation abnormality region. The map (including the line L11 and the line L12) shown in FIG. 8 is stored in the storage device 503.

In the first air bubble determination method, in S11 of FIG. 7, the ECU 500 acquires the order duty and the rotation speed of the pump 131, and in the subsequent S12, the ECU 500 determines whether the state of the pump 131 belongs to the high-speed rotation abnormality region based on the information acquired in S11 and the line L11 in FIG. 8. When the state of the pump 131 belongs to the high-speed rotation abnormality region, the ECU 500 determines that "air bubble inclusion" applies, and when the state of the pump 131 belongs to the normal region or the low-speed rotation abnormality region, the ECU 500 determines that "no air bubble inclusion" applies. That the state of the pump 131 belongs to the high-speed rotation abnormality region means that overspeed rotation of the pump 131 is occurring. When an air accumulation in the heat medium (e.g., water) hits an impeller of the pump 131, as resistance due to the heat medium is lost, overspeed rotation of the pump 131 is likely to occur. When the state of the pump 131 belongs to the high-speed rotation abnormality region, it is considered that overspeed rotation of the pump 131 has temporarily occurred due to air bubbles exceeding the allowable volume that have gotten into the heat medium.

The ECU 500 may determine whether the state of the pump 131 belongs to the low-speed rotation abnormality region based on the line L12. When the state of the pump 131 belongs to the low-speed rotation abnormality region, the ECU 500 may light or sound an alarm relating to the pump 131. However, determination of a low-speed rotation abnormality of the pump 131 and the line L12 are not essential.

FIG. 9 is a view for describing a second air bubble determination method. In FIG. 9, the line L20 shows transition of a temperature detection value (a detection value of the temperature of the heat medium inside the low-temperature flow passage 130) obtained by the flow passage sensor T2. Each of the lines D11, D12 also shows transition of the temperature detection value obtained by the flow passage sensor T2. The flow passage sensor T2 (FIG. 2) includes a temperature sensor (e.g., a water temperature sensor) that detects the temperature of the heat medium inside the low-temperature flow passage 130.

The line D11 and the line D21 represent the temperature detection value and the sensor temperature locus length, respectively, in the case where air bubbles exceeding the allowable volume are not present in the heat medium inside the low-temperature flow passage 130. The line D12 and the line D22 represent the temperature detection value and the sensor temperature locus length, respectively, in the case where air bubbles exceeding the allowable volume are present in the heat medium inside the low-temperature flow passage 130.

Once every unit period having a length dT (e.g., a period t1 to t2, a period t2 to t3, and so on), the ECU 500 integrates a locus of the temperature detection value obtained by the flow passage sensor T2 (an amount that the value has moved) to acquire the sensor temperature locus length. The sensor temperature locus length becomes longer as an amount of fluctuation of the temperature detection value of the heat medium per unit period becomes larger. Each time the unit period elapses, the ECU 500 resets the sensor temperature locus length and starts the integration of the sensor temperature locus length from the initial value (0) again.

In the second air bubble determination method, in S11 of FIG. 7, the ECU 500 acquires (updates) the sensor temperature locus length, and in the subsequent S12, the ECU 500 determines whether the sensor temperature locus length acquired in S11 is equal to or longer than a predetermined value (hereinafter written as "Th10"). When the sensor temperature locus length is equal to or longer than Th10, the ECU 500 determines that "air bubble inclusion" applies (see the line D22), and when the sensor temperature locus length is shorter than Th10, the ECU 500 determines that "no air bubble inclusion" applies (see the line D21). If air bubbles (e.g., numerous small air bubbles) are present in the heat medium, as the temperature sensor (flow passage sensor T2) temporarily detects a gas temperature, the temperature detection value is likely to be affected by the temperature of a surrounding member. Due to the presence of air bubbles, the heat of the heat medium is not easily transferred to the temperature sensor. When the volume of air bubbles present in the heat medium inside the low-temperature flow passage 130 is large, the temperature detection value obtained by the flow passage sensor T2 fluctuates violently. As a result, the sensor temperature locus length becomes longer. When the sensor temperature locus length is equal to or longer than Th10, it is considered that the temperature sensor (flow passage sensor T2) has temporarily detected the temperature of the surrounding member due to air bubbles exceeding the allowable volume that have gotten into the heat medium.

The ECU 500 may implement the first air bubble determination method and the second air bubble determination method in combination. For example, when a phenomenon of either that the state of the pump 131 belongs to the high-speed rotation abnormality region (first phenomenon) or that the sensor temperature locus length is equal to or longer than Th10 (second phenomenon) is detected, the ECU 500 may determine that "air bubble inclusion" applies, and when neither of the phenomena is detected, the ECU 500 may determine that "no air bubble inclusion" applies. The ECU 500 may perform the air bubble determination by other methods. The ECU 500 may use a learned model that has been generated by machine learning of AI (artificial intelligence). For example, the air bubble determination may be performed by a learned model that has learned so as to output a result of the air bubble determination upon receiving an input of at least one of first input data that shows the state of the pump 131 (e.g., at least one of the rotation speed, the current, and the temperature detected by the pump sensor PS2) and second input data that shows the state of the heat medium inside the low-temperature flow passage 130 (e.g., at least one of the temperature and the flow rate of the heat medium detected by the flow passage sensor T2).

When the determination in S12 yields "no air bubble inclusion" in a situation where the coupling conditions are not met (NO in S12), the process proceeds to S15 while the coupling conditions are not met. In S15, the ECU 500 determines whether the time count value is larger than a predetermined time (hereinafter written as "Th1"). Th1 may be, for example, a time not shorter than 30 seconds and not longer than one minute. When the time count value remains the initial value (0), the determination in S15 yields a NO and the process proceeds to S17. In S17, the ECU 500 determines whether the air-bleeding execution flag is "ON." When the air-bleeding execution flag remains the initial value (OFF), the determination in S17 yields a NO and the process proceeds to S50.

In S50, the ECU 500 executes predetermined heat management control (hereinafter referred to as "normal heat management control") in the vehicle 10. In the normal heat management control, the five-way valve 180 (switching device) is permitted to uncouple the low-temperature flow passage 130 and the battery flow passage 170 from each other. Therefore, the ECU 500 can perform heat management of the vehicle 10 in an arbitrary mode (including the modes shown in FIG. 4 to FIG. 6). For example, the ECU 500 switches between coupling and uncoupling of the low-temperature flow passage 130 and the battery flow passage 170 to and from each other according to the state of the vehicle 10. The ECU 500 may switch among the uncoupling mode, the first coupling mode, and the second coupling mode based on outputs of sensors installed in the vehicle 10. The ECU 500 may perform mode selection such that devices (targets of heat management) installed in the vehicle 10 do not reach excessively high temperatures or excessively low temperatures.

When the process of S50 has been executed, the process returns to the first step (S11). While each of the air-bleeding execution flag and the time count value remains the initial value and the determination in S12 yields "no air bubble inclusion," the normal heat management control (S50) is continuously executed.

When the determination in S12 yields "air bubble inclusion" in a situation where the coupling conditions are not met (YES in S12), the process proceeds to S13. In S13, the ECU 500 determines whether the air-bleeding execution flag is "ON." When the air-bleeding execution flag remains the initial value (OFF), the determination in S13 yields a NO, and in the subsequent S14, the ECU 500 sets the air-bleeding execution flag to "ON," and then the process proceeds to S15. As the air-bleeding execution flag is changed from "OFF" to "ON," the coupling conditions switch from being unmet to being met. Meanwhile, the air bleeding control is not being executed, and the time count value is "0" and the air-bleeding execution flag is "ON." Therefore, the determination in S15 yields a NO and the determination in S17 yields a YES, and the process proceeds to S21.

In S21, the ECU 500 determines whether the temperature of the heat medium (third heat medium) inside the low-temperature flow passage 130 is lower than a predetermined temperature (hereinafter written as "Th2"). The ECU 500 may acquire the temperature of the heat medium inside the low-temperature flow passage 130 based on an output of the flow passage sensor T2 (FIG. 2). When the temperature of the heat medium inside the low-temperature flow passage 130 is lower than Th2 (YES in S21), in the subsequent S51, the ECU 500 couples the low-temperature flow passage 130 and the cooling path (flow passage 170a) of the battery flow passage 170 to each other by the five-way valve 180, and makes the third heat medium flow through the low-temperature flow passage 130 and the flow passage 170a. More specifically, the ECU 500 controls the five-way valve 180 such that the heat management system 1 operates in the first coupling mode shown in FIG. 5. Thus, air bleeding of the third heat medium is executed while cooling of the battery 171 is promoted. On the other hand, when the temperature of the heat medium inside the low-temperature flow passage 130 is equal to or higher than Th2 (NO in S21), in the subsequent S52, the ECU 500 couples the low-temperature flow passage 130 and the bypass path (flow passage 170b) of the battery flow passage 170 to each other by the five-way valve 180, and makes the third heat medium flow through the low-temperature flow passage 130 and the flow passage 170b. More specifically, the ECU 500 controls the five-way valve 180 such that the heat management system 1 operates in the second coupling mode shown in FIG. 6. Thus, air bleeding of the third heat medium is executed while a temperature rise of the battery 171 is mitigated. The above-described processes of S21, S51, S52 correspond to the air bleeding control.

As has been described above, in each of S51 and S52, the low-temperature flow passage 130 and the battery flow passage 170 are coupled to each other by the five-way valve 180. Thus, when the coupling conditions are met, the five-way valve 180 (switching device) is prohibited from uncoupling the low-temperature flow passage 130 and the battery flow passage 170 from each other. When the process of either S51 or S52 has been executed, the process proceeds to S22. In S22, the ECU 500 performs time counting (e.g., incrementation of the time count value according to an elapsed time) to update the time count value. The obtained time count value indicates a time that has elapsed since the coupling conditions were met, and corresponds to an execution time (integrated value) of the air bleeding control. When updating of the time count value (S22) has been executed, the process returns to the first step (S11).

While the coupling conditions are met, the determination in S15 yields a NO and the determination in S17 yields a YES. Therefore, the air bleeding control (S21, S51, S52) is continuously executed. During a period when the coupling conditions are met, the ECU 500 determines in S15 whether the air bleeding of the third heat medium has been completed. When Th1 has elapsed since the coupling conditions were met, the time count value reaches Th1. Thus, it is determined that the air bleeding of the third heat medium has been completed (YES in S15) and the process proceeds to S16.

In S16, the ECU 500 returns the air-bleeding execution flag and the time count value to their respective initial values. Thus, the air-bleeding execution flag is changed from "ON" to "OFF" and the coupling conditions switch from being met to being unmet. Thereafter, the process proceeds to S17, and the determination in S17 yields a NO and the process proceeds to S50. Thus, the air bleeding control (S21, S51, S52) is not executed. Until a predetermined period has elapsed since the air bleeding of the third heat medium was completed, the heat management system 1 may be maintained in the uncoupling mode by the normal heat management control (S50).

As has been described above, the ECU 500 (control device) is configured to be able to execute the heat management control of the vehicle 10 using the coupling mode in which the first flow passage and the second flow passage are coupled to each other and the uncoupling mode in which the first flow passage and the second flow passage are uncoupled from each other. While the coupling conditions are not met, the ECU 500 executes the heat management control using the coupling mode and the uncoupling mode. When the ECU 500 detects that air bubbles exceeding the allowable volume are present in the heat medium (third heat medium), the coupling conditions switch from being unmet to being met, and the air bleeding control that maintains the heat management system 1 in the coupling mode is executed. While the coupling conditions are met, the ECU 500 executes the air bleeding control. Then, when the predetermined time (Th1) has elapsed since the coupling conditions were met, the coupling conditions switch from being met to being unmet and the ECU 500 switches from the air bleeding control to the heat management control. This heat management system 1 makes it possible to make a heat medium flow through a flow passage uncoupled from a reserve tank as necessary while reducing the volume of air bubbles in the heat medium.

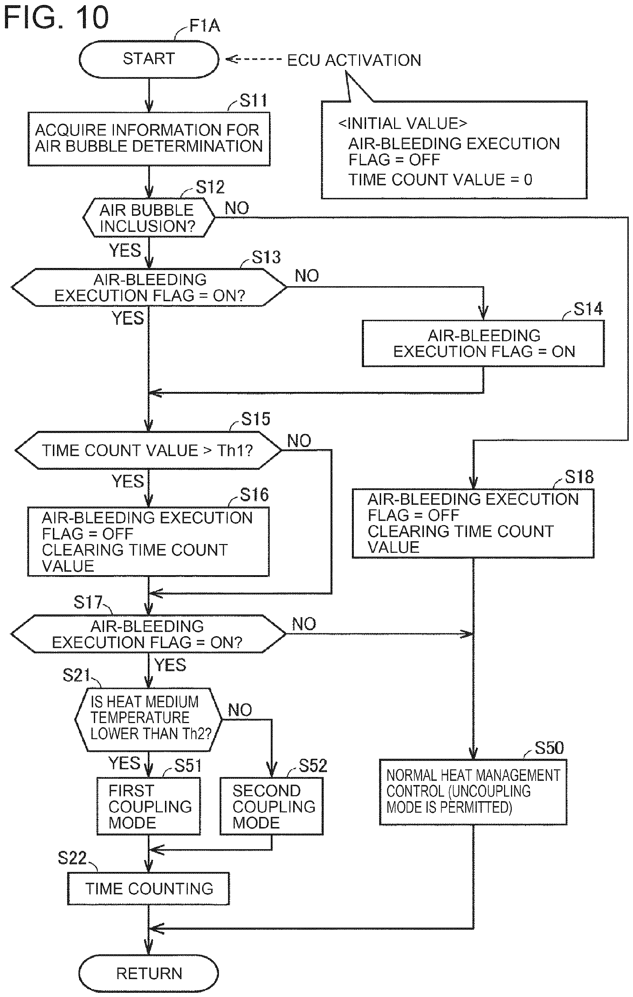

In the above-described embodiment, when the predetermined time has elapsed since the coupling conditions were met, it is determined that the air bleeding of the heat medium has been completed and the coupling conditions switch from being met to being unmet. As the air bleeding control is continuously executed for the predetermined time (Th1), sufficient air bleeding is likely to be executed. However, the method for determining whether the air bleeding of the heat medium has been completed is arbitrary. For example, the ECU 500 may execute the process flow F1A shown in FIG. 10 instead of the process flow F1 shown in FIG. 7.

FIG. 10 is a flowchart showing a modified example of the process flow F1 shown in FIG. 7. The process flow F1A shown in FIG. 10 is the same as the process flow F1 (FIG. 7) except that S18 has been added. Referring to FIG. 10, in this modified example, when the determination in S12 yields "no air bubble inclusion," the process proceeds to S18. In S18, the ECU 500 returns the air-bleeding execution flag and the time count value to their respective initial values. During a period when the coupling conditions are met, the determination in S12 corresponds to the determination as to whether the air bleeding of the third heat medium has been completed. Specifically, during the period when the coupling conditions are met, the ECU 500 determines in S12 whether the air bleeding of the third heat medium has been completed based on whether or not the volume of air bubbles in the heat medium has become equal to or smaller than the allowable volume. When the determination in S12 yields "no air bubble inclusion" (NO in S12), it is determined that the air bleeding of the third heat medium has been completed and the process proceeds to S18. Then, by the process of S18, the air-bleeding execution flag is changed from "ON" to "OFF" and the coupling conditions switch from being met to being unmet. Thus, the air bleeding control (S21, S51, S52) switch to the heat management control (S50).

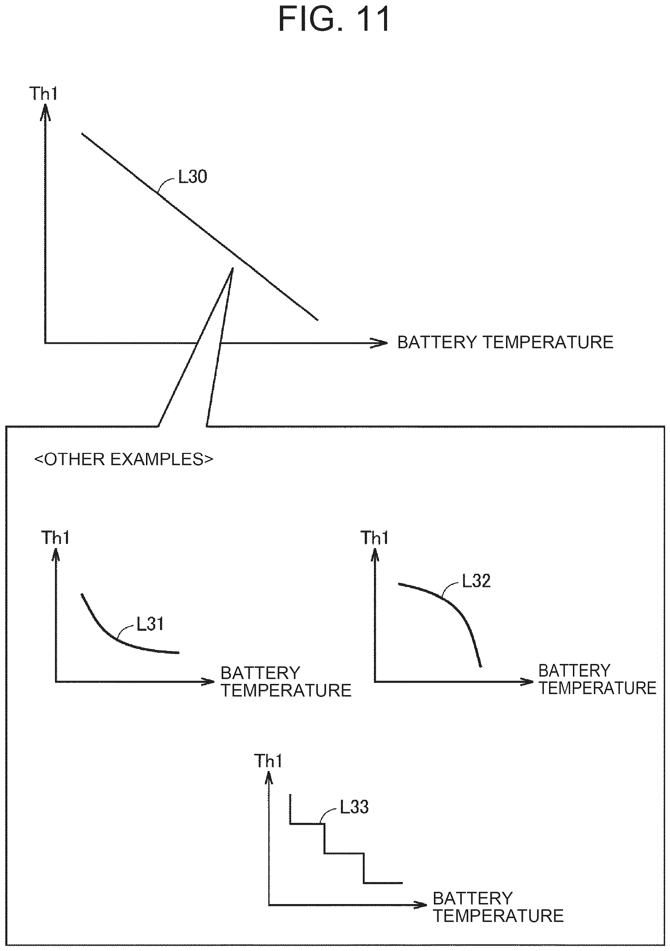

In the above-described embodiment, Th1 is set according to the time needed to complete the air bleeding. However, without being limited thereto, Th1 may vary according to the temperature of the battery 171 (a heating element provided in the second flow passage). FIG. 11 is a view for describing a modified example of the setting method of Th1 (a threshold value used for the air-bleeding ending determination). Referring to FIG. 11, the ECU 500 may set Th1, for example, using a map represented by the line L30, such that Th1 becomes smaller as the temperature of the battery 171 becomes higher. In the line L30, a change rate indicated by the inclination of the graph (the ratio of a change in Th1 relative to a change in the temperature of the battery 171) is constant. However, without being limited thereto, the change rate may become lower or higher as the temperature of the battery 171 becomes higher as indicated by the line L31 or the line L32. Or Th1 may vary stepwise according to the temperature of the battery 171 as indicated by the line L33. In the process flow F1 (FIG. 7) or the process flow F1A (FIG. 10) that adopts Th1 thus set, when the predetermined time (Th1) has elapsed since the coupling conditions were met, the coupling conditions switch from being met to being unmet (S15 and S16). According to the above-described maps (lines L30 to L33), the predetermined time (Th1) becomes shorter as the temperature of the battery 171 becomes higher. This control helps achieve both cooling of the heating element (battery 171) provided in the second flow passage and air bleeding of the heat medium inside the first flow passage (low-temperature flow passage 130). Instead of time, the flow rate may be adopted. In S22, the ECU 500 may integrate the flow rate of the third heat medium (e.g., the flow rate detected by the flow passage sensor T2) instead of time, and in S15, the ECU 500 may compare the integrated value of the flow rate and the predetermined value (Th1).

It is not essential for the ECU 500 to execute the process flow F1 or F1A all the time when operating. The ECU 500 may execute the process flow F1 or F1A only in a predetermined situation (e.g., when the temperature of the battery 171 is equal to or lower than a predetermined temperature). The ECU 500 may execute the process flow F1 or F1A while the vehicle 10 is traveling, and may execute the air bleeding control by a process flow that is not shown (a different algorithm) while the vehicle 10 is stationary or being externally charged.

### Second Embodiment

In the following, a second embodiment will be described with a focus on differences from the first embodiment.

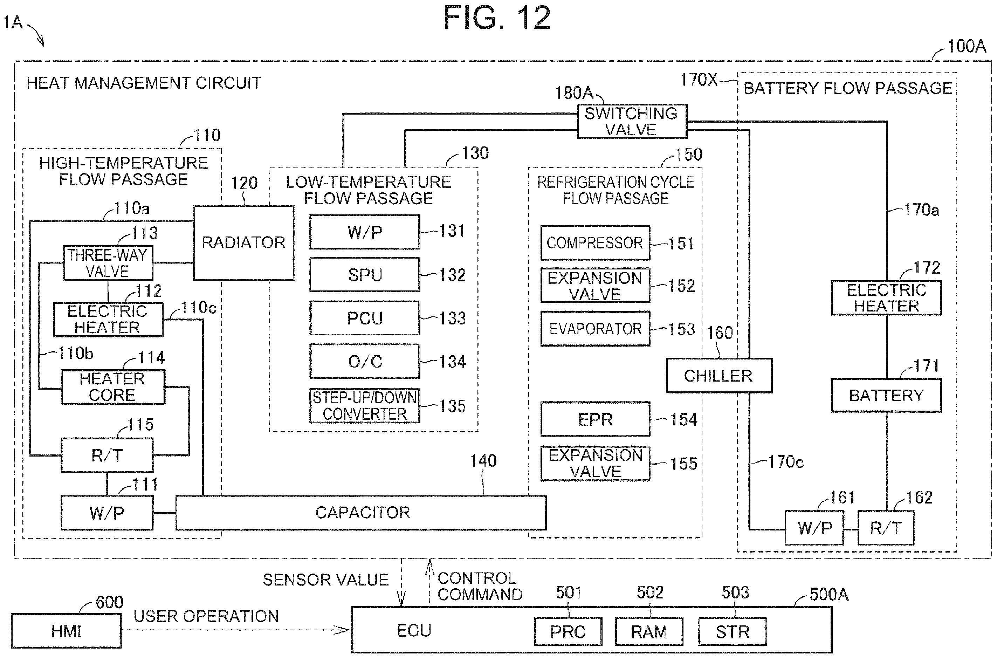

FIG. 12 is a view showing the configuration of a heat management system according to the second embodiment. Referring to FIG. 12, a heat management system 1A includes a heat management circuit 100A and an ECU 500A instead of the heat management circuit 100 and the ECU 500 (FIG. 1). The heat management circuit 100A includes a battery flow passage 170X instead of the battery flow passage 170 (FIG. 1). The battery flow passage 170X has basically the same configuration as the battery flow passage 170 (FIG. 1), but does not have the bypass path (flow passage 170b). The heat management circuit 100A includes a switching valve 180A instead of the five-way valve 180 (FIG. 1). As the switching valve 180A, the five-way valve shown in FIG. 1 can be adopted. In the switching valve 180A, however, the bypass path (flow passage 170b) is not connected to the port P4. Therefore, the switching valve 180A virtually functions as a four-way valve.

The heat management system 1A can operate in an uncoupling mode and a coupling mode to be described below.

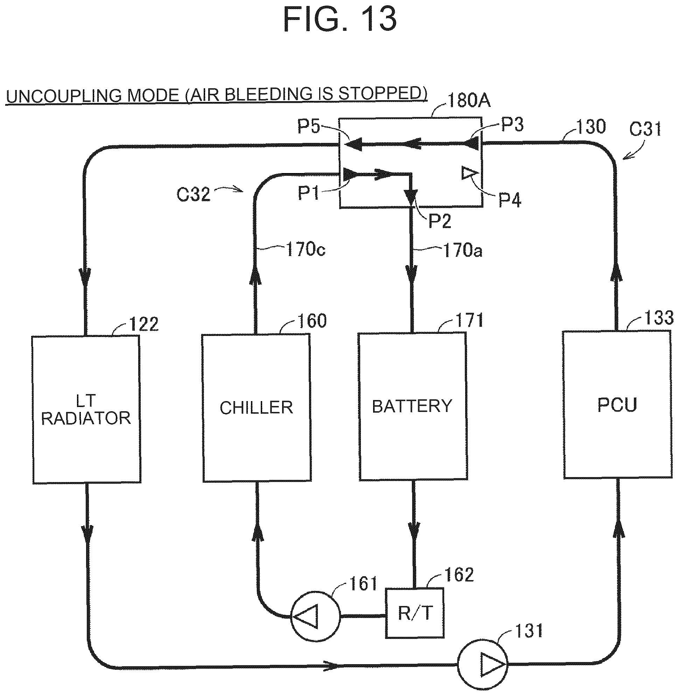

FIG. 13 is a view for describing the uncoupling mode of the heat management system 1A. Referring to FIG. 13, in the uncoupling mode, in the switching valve 180A, the port P1 and the port P2 are connected to each other and the port P3 and the port P5 are connected to each other. Thus, circuits C31 and C32 that are uncoupled from each other are formed. These circuits C31 and C32 are formed similarly to the circuits C11 and C12, respectively, shown in FIG. 4. In the uncoupling mode, the pumps 131 and 161 are driven, and the pump 131 circulates the heat medium through the circuit C31 while the pump 161 circulates the heat medium through the circuit C32. In the uncoupling mode, the circuit C31 (including the low-temperature flow passage 130) is uncoupled from the reserve tank.

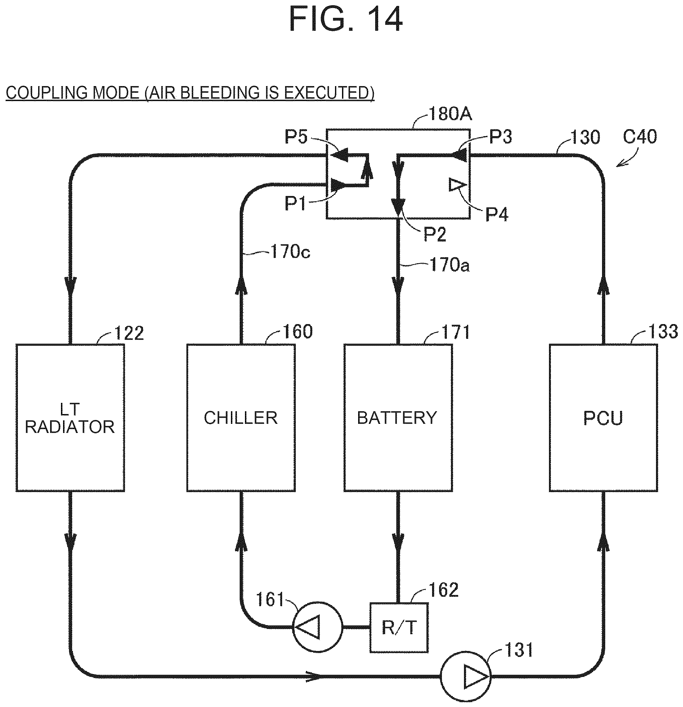

FIG. 14 is a view for describing the coupling mode of the heat management system 1A. Referring to FIG. 14, in the coupling mode, in the switching valve 180A, the port P1 and the port P5 are connected to each other and the port P2 and the port P3 are connected to each other. Thus, a circuit C40 is formed similarly to the circuit C21 shown in FIG. 5. In the coupling mode, the pumps 131 and 161 enter an operating state and circulate the heat medium through the circuit C40. However, without being limited thereto, the ECU 500A may stop the pump 161 in the coupling mode. In the coupling mode, as the low-temperature flow passage 130 is connected to the battery flow passage 170 in which the reserve tank 162 is provided, air bleeding of the heat medium (third heat medium) inside the low-temperature flow passage 130 is performed.

The switching valve 180A is not limited to a five-way valve and may instead be other multi-way valve (e.g., a four-way valve, a six-way valve, a seven-way valve, an eight-way valve, a nine-way valve, or a ten-way valve).

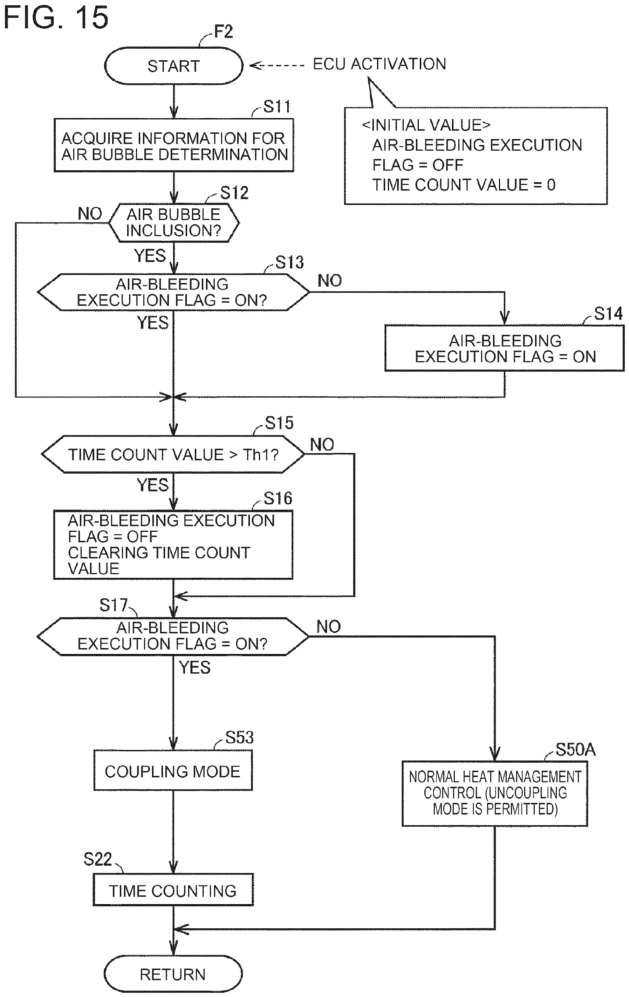

FIG. 15 is a flowchart showing air-bleeding execution control in the second embodiment. The ECU 500A has basically the same configuration as the ECU 500 (FIG. 1), but executes the process flow F2 shown in FIG. 15 instead of the process flow F1 (FIG. 7). The process flow F2 shown in FIG. 15 is the same as the process flow F1 except that S53 and S50A are adopted instead of S21 and S50 to S52 (FIG. 7).

In the process flow F2, when the coupling conditions are met, the determination in S17 yields a YES and the air bleeding control is executed in S53. In S53, the ECU 500A couples the low-temperature flow passage 130 and the flow passage 170a to each other by the switching valve 180A and makes the third heat medium flow through the low-temperature flow passage 130 and the flow passage 170a. More specifically, the ECU 500A controls the switching valve 180A such that the heat management system 1A operates in the coupling mode shown in FIG. 14. Thus, air bleeding of the third heat medium is executed. Thereafter, the process proceeds to S22.

On the other hand, when the coupling conditions are not met, the determination in S17 yields a NO and the heat management control is executed in S50A. The heat management control in S50A is basically the same as the normal heat management control in S50 of FIG. 7. In S50A, however, the modes shown in FIG. 13 and FIG. 14 are adopted instead of the modes shown in FIG. 4 to FIG. 6. In S50A, the switching valve 180A (switching device) is permitted to uncouple the low-temperature flow passage 130 and the battery flow passage 170 from each other. The ECU 500A may switch between the uncoupling mode (FIG. 13) and the coupling mode (FIG. 14) according to the state of the vehicle equipped with the heat management system 1A.

The heat management system 1A according to the second embodiment having been described above also makes it possible to make a heat medium flow through a flow passage uncoupled from a reserve tank as necessary while reducing the volume of air bubbles in the heat medium.

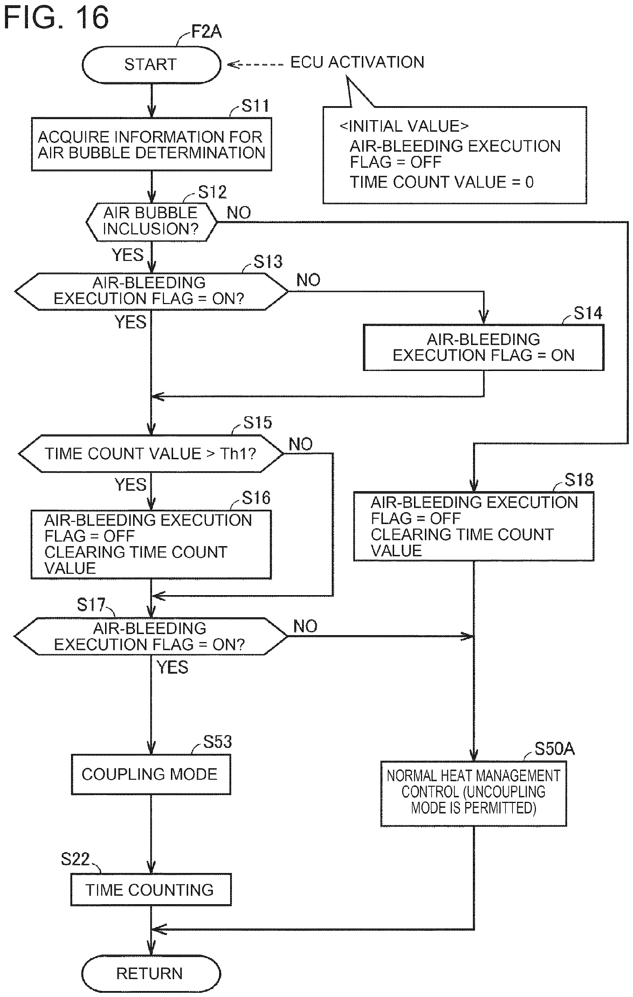

The ECU 500A may be configured to execute the process flow F2A shown in FIG. 16 instead of the process flow F2 (FIG. 15). FIG. 16 is a flowchart showing a modified example of the process flow shown in FIG. 15. The process flow F2A shown in FIG. 16 is the same as the process flow F2 (FIG. 15) except that S18 has been added. S18 of the process flow F2A is the same as S18 of the above-described process flow F1A (FIG. 10).

In each of the process flows F2 and F2A, Th1 may be a fixed value or may be variable. The ECU 500A may set Th1, for example, using the map shown in FIG. 11 (one of the lines L30 to L33), such that Th1 becomes smaller as the temperature of the battery 171 becomes higher. Instead of time (time count value), the flow rate may be adopted.

It is not essential for the ECU 500A to execute the process flow F2 or F2A all the time when operating. The ECU 500A may execute the process flow F2 or F2A only in a predetermined situation (e.g., when the temperature of the battery 171 is equal to or lower than a predetermined temperature). The ECU 500A may execute the process flow F2 or F2A while the vehicle equipped with the heat management system 1A is traveling, and may execute the air bleeding control by a process flow that is not shown (a different algorithm) while that vehicle is stationary or being externally charged.

### Other Embodiments

The configuration of the heat management system is not limited to that shown in FIG. 1 or FIG. 12. In the following, modified examples of the configuration of the heat management system will be described.

### First Modified Example of Configuration of Heat Management System

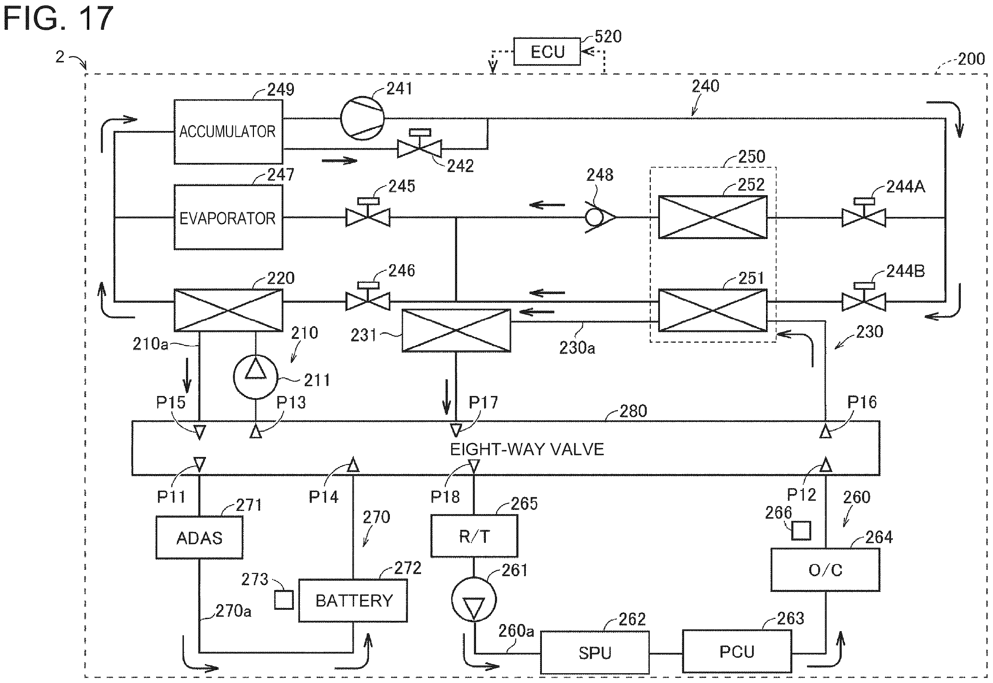

FIG. 17 is a view showing a first modified example of the configuration of the heat management system shown in FIG. 1. A heat management system 2 shown in FIG. 17 includes a heat management circuit 200 and an ECU 520. The heat management circuit 200 includes a capacitor 250, a refrigeration cycle flow passage 240 connected to the capacitor 250, and an eight-way valve 280. The eight-way valve 280 includes eight ports P11 to P18. The heat management circuit 200 further includes a chiller circuit 210, a radiator circuit 230, a driving unit circuit 260, and a battery circuit 270 that are connected to the eight-way valve 280. The heat management circuit 200 is controlled by the ECU 520.

The chiller circuit 210 includes a flow passage 210a. The flow passage 210a is a flow passage that connects the ports P13 and P15 of the eight-way valve 280 to each other. In the flow passage 210a, a pump 211 and a chiller 220 are provided. The pump 211 is, for example, a water pump. The chiller 220 is connected to (shared by) both the chiller circuit 210 and the refrigeration cycle flow passage 240. The chiller 220 performs heat exchange between a heat medium circulating through the chiller circuit 210 and a heat medium circulating through the refrigeration cycle flow passage 240. The radiator circuit 230 includes a flow passage 230a. The flow passage 230a is a flow passage that connects the ports P16 and P17 of the eight-way valve 280 to each other. In the flow passage 230a, a radiator 231 is provided. The radiator 231 is disposed downstream of a grille shutter (not shown) and exchanges heat between air outside the vehicle and the heat medium.

In the refrigeration cycle flow passage 240, a compressor 241, an electromagnetic valve 242, electromagnetic valves 244A, 244B, 245, 246, an evaporator 247, a check valve 248, and an accumulator 249 are provided. The capacitor 250 includes a water-cooled capacitor 251 and an air-cooled capacitor 252. The water-cooled capacitor 251 is connected to both the refrigeration cycle flow passage 240 and the radiator circuit 230.

The compressor 241 compresses a gas-phase refrigerant circulating through the refrigeration cycle flow passage 240 according to a control command from the ECU 520. The electromagnetic valve 242 is connected in parallel to the compressor 241, and adjusts an amount of gas-phase refrigerant flowing into the compressor 241 according to a control command from the ECU 520. The electromagnetic valves 244A and 244B switch the gas-phase refrigerant discharged from the compressor 241 between flowing into the water-cooled capacitor 251 and flowing into the air-cooled capacitor 252 according to a control command from the ECU 520. The water-cooled capacitor 251 makes the gas-phase refrigerant discharged from the compressor 241 and the heat medium flowing through the radiator circuit 230 exchange heat with each other. The air-cooled capacitor 252 exchanges heat with air introduced into a vehicle cabin to create a warm wind. The electromagnetic valve 245 restricts an inflow of a liquid-phase refrigerant into the evaporator 247 according to a control command from the ECU 520. The electromagnetic valve 246 restricts an inflow of the liquid-phase refrigerant into the chiller 220 according to a control command from the ECU 520. The electromagnetic valves 245 and 246 have a function of expanding the liquid-phase refrigerant. The accumulator 249 removes the liquid-phase refrigerant from the refrigerant in a state of a gas-liquid mixture, and when the refrigerant has not been completely gasified by the evaporator 247, inhibits the liquid-phase refrigerant from becoming sucked into the compressor 241.

The driving unit circuit 260 includes a flow passage 260a. The flow passage 260a is a flow passage that connects the ports P12 and P18 of the eight-way valve 280 to each other. In the flow passage 260a, a pump 261, an SPU 262, a PCU 263, an oil cooler 264, a reserve tank 265, and a heat medium temperature sensor 266 are provided. The reserve tank 265 stores part of the heat medium inside the driving unit circuit 260 (the heat medium that has overflowed as the pressure has risen) so as to maintain the pressure and the amount of the heat medium inside the driving unit circuit 260. The heat medium temperature sensor 266 detects the temperature of the heat medium inside the flow passage 260a.

The pump 261 is, for example, a water pump. The SPU 262 controls charging and discharging of the battery 272 according to a control command from the ECU 520. The PCU 263 converts direct-current electricity supplied from the battery 272 into alternating-current electricity and supplies this alternating-current electricity to a motor (not shown) incorporated in a transaxle according to a control command from the ECU 520. The oil cooler 264 cools the transaxle by heat exchange between the heat medium circulating through the driving unit circuit 260 and lubricating oil of the motor. Heat that is generated as electricity is supplied to a stator of the motor without a rotor thereof being rotated may be transferred to the heat medium circulating through the driving unit circuit 260. The SPU 262, the PCU 263, and the oil cooler 264 are cooled by the heat medium circulating through the driving unit circuit 260.

The battery circuit 270 includes a flow passage 270a. The flow passage 270a is a flow passage that connects the ports P11 and P14 of the eight-way valve 280 to each other. In the flow passage 270a, no reserve tank is provided. In the flow passage 270a, advanced driver-assistance systems (ADAS) 271, a battery 272, and a temperature sensor 273 are provided. The battery circuit 270 may further include an autonomous driving system (ADS) in addition to the ADAS 271. The battery 272 may supply electricity for traveling to the motor incorporated in the transaxle. The temperature sensor 273 detects the temperature of the battery 272.

The eight-way valve 280 switches the path for the heat medium to flow through according to a control command from the ECU 520. The heat management system 2 can operate in an uncoupling mode, a first coupling mode, a second coupling mode, and a third coupling mode to be described below.

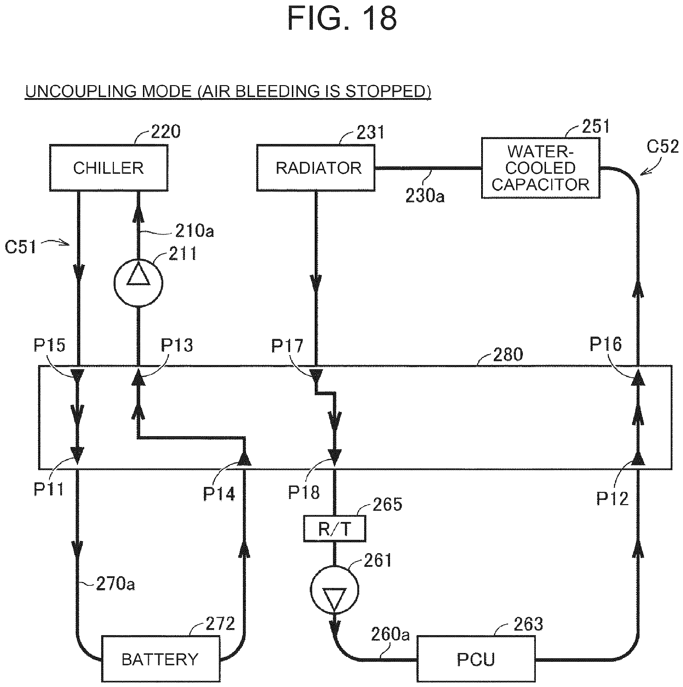

FIG. 18 is a view for describing the uncoupling mode of the heat management system 2. Referring to FIG. 18, in the uncoupling mode, in the eight-way valve 280, the ports P11 and P15, the ports P12 and P16, the ports P13 and P14, and the ports P17 and P18 are connected to each other. Thus, circuits C51 and C52 that are uncoupled from each other are formed. The circuit C51 is a fluid circuit in which the port P11, the flow passage 270a, the port P14, the port P13, the flow passage 210a, and the port P15 are sequentially connected to one another. In the uncoupling mode, the pump 211 is driven and the pump 211 circulates the heat medium through the circuit C51. Thus, the heat medium having flowed from the flow passage 210a into the port P15 is output from the port P11 to the flow passage 270a and flows into the port P14 through the flow passage 270a. Further, the heat medium having flowed into the port P14 is output from the port P13 to the flow passage 210a. The circuit C52 is a fluid circuit in which the port P16, the flow passage 230a, the port P17, the port P18, the flow passage 260a, and the port P12 are sequentially connected to one another. In the uncoupling mode, the pump 261 is also driven and the pump 261 circulates the heat medium through the circuit C52. Thus, the heat medium having flowed from the flow passage 260a into the port P12 is output from the port P16 to the flow passage 230a and flows into the port P17 through the flow passage 230a. Further, the heat medium having flowed into the port P17 is output from the port P18 to the flow passage 260a. In the uncoupling mode, the circuit C51 (including the flow passage 270a) is uncoupled from the reserve tank. Therefore, air bleeding of the heat medium inside the flow passage 270a is not performed.

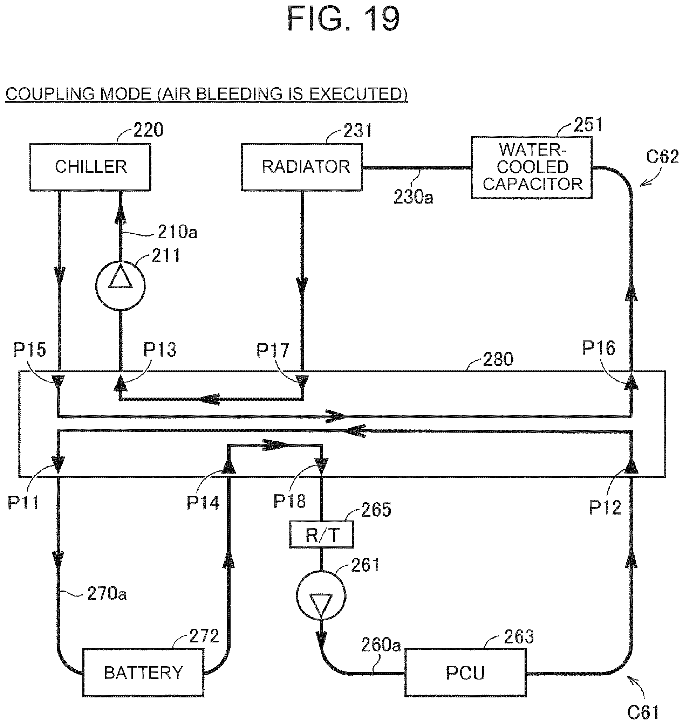

FIG. 19 is a view for describing the first coupling mode of the heat management system 2. Referring to FIG. 19, in the first coupling mode, in the eight-way valve 280, the ports P11 and P12, the ports P13 and P17, the ports P14 and P18, and the ports P15 and P16 are connected to each other. Thus, circuits C61 and C62 that are uncoupled from each other are formed. The circuit C61 is a fluid circuit in which the port P11, the flow passage 270a, the port P14, the port P18, the flow passage 260a, and the port P12 are sequentially connected to one another. In the first coupling mode, the pump 261 is driven and the pump 261 circulates the heat medium through the circuit C61. Thus, the heat medium having flowed from the flow passage 260a into the port P12 is output from the port P11 to the flow passage 270a and flows into the port P14 through the flow passage 270a. Further, the heat medium having flowed into the port P14 is output from the port P18 to the flow passage 260a. The circuit C62 is a fluid circuit in which the port P16, the flow passage 230a, the port P17, the port P13, the flow passage 210a, and the port P15 are sequentially connected to one another. In the first coupling mode, the pump 211 is also driven and the pump 211 circulates the heat medium through the circuit C62. Thus, the heat medium having flowed from the flow passage 210a into the port P15 is output from the port P16 to the flow passage 230a and flows into the port P17 through the flow passage 230a. Further, the heat medium having flowed into the port P17 is output from the port P13 to the flow passage 210a. In the first coupling mode, the flow passage 270a and the flow passage 260a are coupled to each other by the eight-way valve 280. As the flow passage 270a is connected to the flow passage 260a in which the reserve tank 265 is provided, air bleeding of the heat medium inside the flow passage 270a is performed.

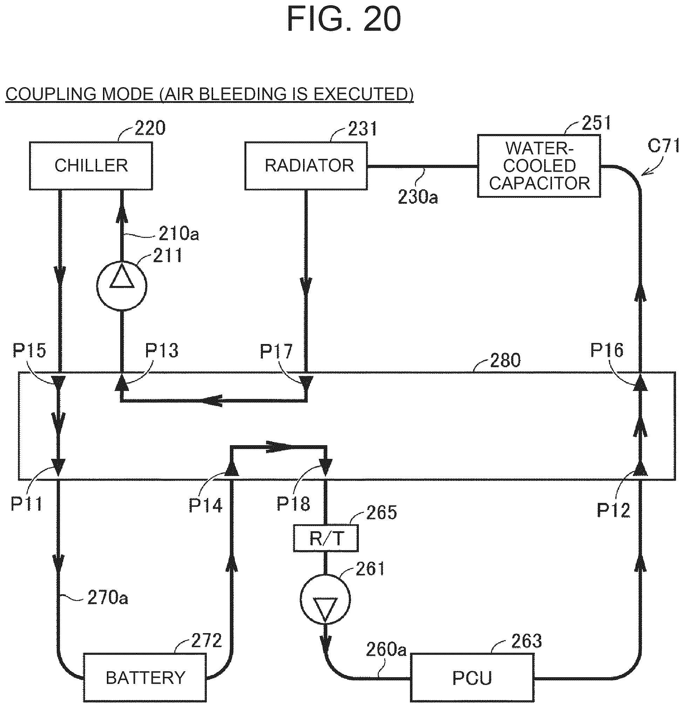

FIG. 20 is a view for describing the second coupling mode of the heat management system 2. Referring to FIG. 20, in the second coupling mode, in the eight-way valve 280, the ports P11 and P15, the ports P12 and P16, the ports P13 and P17, and the ports P14 and P18 are connected to each other. Thus, a circuit C71 is formed. The circuit C71 is a fluid circuit in which the port P11, the flow passage 270a, the port P14, the port P18, the flow passage 260a, the port P12, the port P16, the flow passage 230a, the port P17, the port P13, the flow passage 210a, and the port P15 are sequentially connected to one another. In the second coupling mode, the pumps 211 and 261 enter an operating state and circulate the heat medium through the circuit C71. Thus, the heat medium having flowed from the flow passage 210a into the port P15 is output from the port P11 to the flow passage 270a, flows into the port P14 through the flow passage 270a, and is output from the port P18 to the flow passage 260a. Further, the heat medium flows into the port P12 through the flow passage 260a, is output from the port P16 to the flow passage 230a, flows into the port P17 through the flow passage 230a, and is output from the port P13 to the flow passage 210a. In the second coupling mode, the flow passage 270a and the flow passage 260a are coupled to each other by the eight-way valve 280. As the flow passage 270a is connected to the flow passage 260a in which the reserve tank 265 is provided, air bleeding of the heat medium inside the flow passage 270a is performed. The ECU 520 may stop the pump 261 in the second coupling mode.

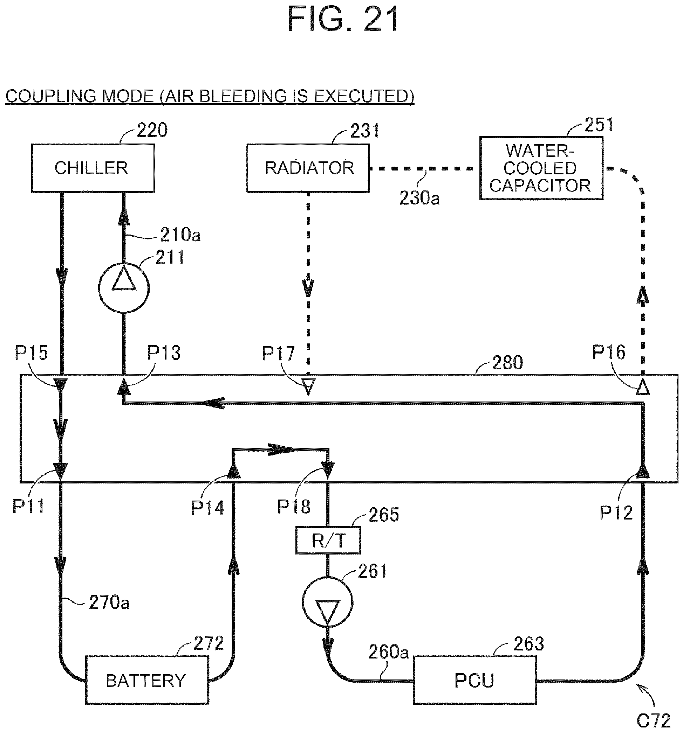

FIG. 21 is a view for describing the third coupling mode of the heat management system 2. Referring to FIG. 21, in the third coupling mode, in the eight-way valve 280, the ports P11 and P15, the ports P12 and P13, and the ports P14 and P18 are connected to each other. Neither of the ports P16 and P17 is connected to any other port. Thus, a circuit C72 is formed. The circuit C72 is a fluid circuit in which the port P11, the flow passage 270a, the port P14, the port P18, the flow passage 260a, the port P12, the port P13, the flow passage 210a, and the port P15 are sequentially connected to one another. In the third coupling mode, the pumps 211 and 261 enter the operating state and circulate the heat medium through the circuit C72. Thus, the heat medium having flowed from the flow passage 210a into the port P15 is output from the port P11 to the flow passage 270a, flows into the port P14 through the flow passage 270a, and is output from the port P18 to the flow passage 260a. Further, the heat medium flows into the port P12 through the flow passage 260a and is output from the port P13 to the flow passage 210a. In the third coupling mode, the flow passage 270a and the flow passage 260a are coupled to each other by the eight-way valve 280. As the flow passage 270a is connected to the flow passage 260a in which the reserve tank 265 is provided, air bleeding of the heat medium inside the flow passage 270a is performed. The ECU 520 may stop the pump 261 in the third coupling mode.

The ECU 520 may execute the process flow F2 shown in FIG. 15 or the process flow F2A shown in FIG. 16. In this modified example, however, instead of the modes shown in FIG. 13 and FIG. 14, the modes shown in FIG. 18 to FIG. 21 are adopted. When the coupling conditions are not met, the uncoupling mode is permitted in S50A. In S50A, the ECU 520 may switch among the uncoupling mode (FIG. 18), the first coupling mode (FIG. 19), the second coupling mode (FIG. 20), and the third coupling mode (FIG. 21) according to the state of the vehicle equipped with the heat management system 2. When the coupling conditions are met, in S53, the coupling mode is maintained and the uncoupling mode is prohibited. In S53, the ECU 520 controls the eight-way valve 280 such that the heat management system 2 operates in one of the first to third coupling modes. Thus, air bleeding of the heat medium inside the flow passage 270a is performed. In S53, the ECU 520 may select one coupling mode among the first to third coupling modes such that devices (targets of heat management) installed in the vehicle do not reach excessively high temperatures or excessively low temperatures. In this modified example, the eight-way valve 280, the flow passage 270a, the flow passage 260a, and the ECU 520 correspond to "switching device," "first flow passage," "second flow passage," and "control device," respectively, according to this disclosure.

In a form in which a bypass path that bypasses the battery 272 is provided in the heat management circuit 200, the ECU 520 may execute the process flow F1 shown in FIG. 7 or the process flow F1A shown in FIG. 10. For example, a bypass path may be added to the battery circuit 270, and a port leading to the bypass path may be added to the eight-way valve 280 (switching device). The switching device (the eight-way valve 280 having the additional port) may be configured such that a valve body rotates according to an order from the ECU 520 so as to selectively connect one of the port P14 leading to the path in which the battery 272 is provided (cooling path) and the port leading to the bypass path. A bypass path and a port therefor may be added to a component other than the battery 272 (e.g., the radiator 231).

### Second Modified Example of Configuration of Heat Management System

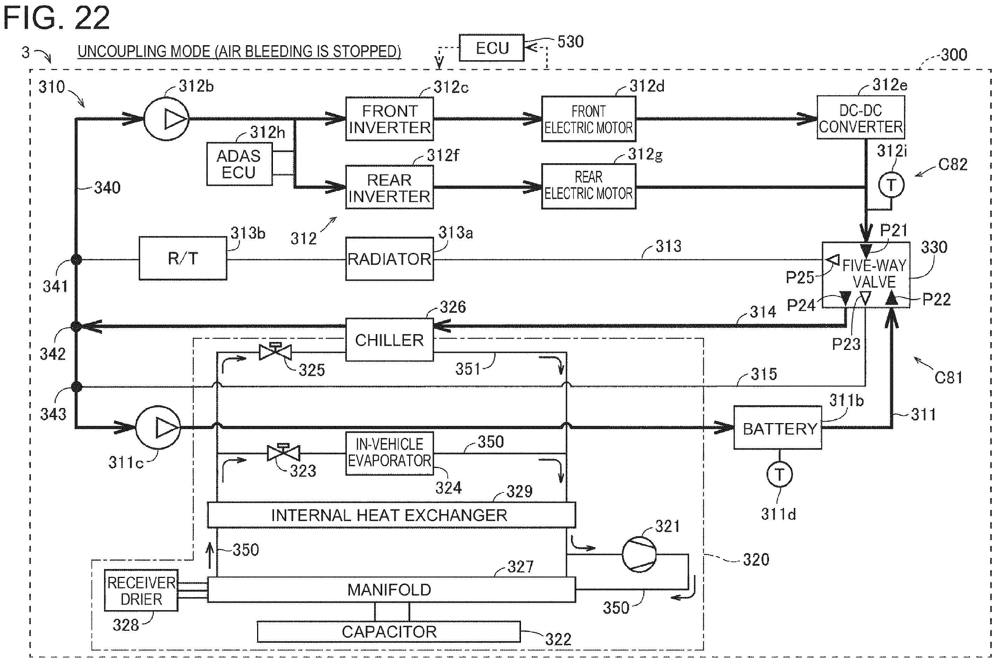

FIG. 22 is a view showing a second modified example of the configuration of the heat management system shown in FIG. 1. A heat management system 3 shown in FIG. 22 includes a heat management circuit 300 and an ECU 530. The heat management circuit 300 includes a heat medium circuit 310 and a refrigeration circuit 320. The heat medium circuit 310 and the refrigeration circuit 320 share a chiller 326.

The heat medium circuit 310 includes flow passages 311 to 315, 340, pumps 311c, 312b, and a five-way valve 330. The five-way valve 330 has ports P21 to P25. Each of the pumps 311c, 312b is, for example, a water pump. The flow passage 340 is a flow passage that connects the pumps 311c and 312b to each other. The flow passage 340 includes junctions 341, 342, 343.

The flow passage 311 is a flow passage that connects the port P22 of the five-way valve 330 and the pump 311c to each other. In the flow passage 311, a battery 311b and a temperature sensor 311d are provided. The temperature sensor 311d detects the temperature of the battery 311b. The flow passage 312 is a flow passage that connects the port P21 of the five-way valve 330 and the pump 312b to each other. In the flow passage 312, a front inverter 312c, a front electric motor 312d, a DC-DC converter 312e, a rear inverter 312f, a rear electric motor 312g, an ADAS-ECU 312h, and a temperature sensor 312i are provided. The temperature sensor 312i detects the temperature of the heat medium flowing through the flow passage 312. In neither of the flow passages 311, 312, a reserve tank is provided. The flow passage 313 is a flow passage that connects the port P25 of the five-way valve 330 and the junction 341 to each other. In the flow passage 313, a radiator 313a and a reserve tank 313b are provided. The flow passage 314 is a flow passage that connects the port P24 of the five-way valve 330 and the junction 342 to each other. In the flow passage 314, the chiller 326 is provided. The flow passage 315 is a flow passage connecting the port P23 of the five-way valve 330 and the junction 343 to each other.

The refrigeration circuit 320 includes a circulation flow passage 350, a bypass flow passage 351, and an internal heat exchanger 329. The circulation flow passage 350 is a flow passage through which a working medium (e.g., water) circulates. In the circulation flow passage 350, a compressor 321, a capacitor 322, a first expansion valve 323, an in-vehicle evaporator 324, and a manifold 327 are provided. A receiver drier 328 is connected to the manifold 327. The bypass flow passage 351 is connected to the circulation flow passage 350 so as to bypass the in-vehicle evaporator 324. In the bypass flow passage 351, a second expansion valve 325 and a chiller 326 are provided. An internal heat exchanger 329 is connected to a portion of the circulation flow passage 350 on an upstream side of the first expansion valve 323 and a portion of the circulation flow passage 350 on a downstream side of the in-vehicle evaporator 324.

In the circulation flow passage 350, the compressor 321 compresses the working medium. The capacitor 322 condenses the working medium having been discharged from the compressor. The first expansion valve 323 expands the working medium having flowed out of the capacitor 322. The in-vehicle evaporator 324 makes the working medium having flowed out of the first expansion valve 323 and air inside the vehicle cabin exchange heat with each other. The chiller 326 performs heat exchange between the heat medium flowing through the flow passage 314 and the working medium flowing through the bypass flow passage 351.

The five-way valve 330 may switch the flow passage of the heat management circuit 300 according to a control command from the ECU 530 to thereby make the heat management system 3 operate in one of a warming mode in which the battery 311b is warmed, a cooling mode in which the battery 311b is cooled, a vehicle inside cooling mode, a vehicle inside heating mode, and a mode combining some of these modes. The heat management system 3 can operate in an uncoupling mode, a first coupling mode, a second coupling mode, and a third coupling mode to be described below.

The heat management system 3 shown in FIG. 22 is operating in the uncoupling mode. In the uncoupling mode, in the five-way valve 330, the port P24 is connected to each of the ports P21, P22. Neither of the ports P23, P25 is connected to any other port. Thus, circuits C81 and C82 are formed. The circuit C81 is a fluid circuit in which the port P24, the flow passage 314, the flow passage 340, the pump 311c, the flow passage 311, and the port P22 are sequentially connected to one another. The circuit C82 is a fluid circuit in which the port P24, the flow passage 314, the flow passage 340, the pump 312b, the flow passage 312, and the port P21 are sequentially connected to one another. In the uncoupling mode, the pumps 311c and 312b are driven and these pumps circulate the heat medium through the circuits C81 and C82. The heat medium having flowed out from the port P24 to the flow passage 314 splits at the junction 342 to flow through the flow passage 340 toward each of the flow passage 311 and the flow passage 312. The heat medium having been pressurized by the pump 31 1c flows into the port P22 through the flow passage 311. The heat medium having been pressurized by the pump 312b flows into the port P21 through the flow passage 312. In the uncoupling mode, each of the circuits C81 and C82 is uncoupled from the reserve tank. Therefore, air bleeding of the heat medium is not performed in either of the flow passages 311, 312.

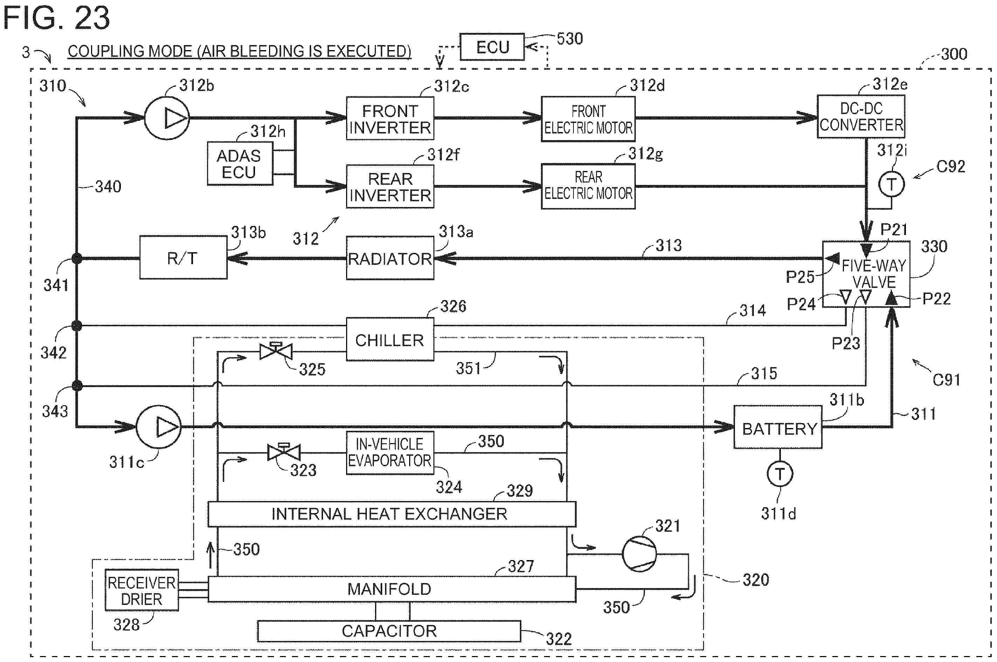

FIG. 23 is a view for describing the first coupling mode of the heat management system 3. Referring to FIG. 23, in the first coupling mode, in the five-way valve 330, the port P25 is connected to each of the ports P21, P22. Neither of the ports P23, P24 is connected to any other port. Thus, circuits C91 and C92 are formed. The circuit C91 is a fluid circuit in which the port P25, the flow passage 313, the flow passage 340, the pump 311c, the flow passage 311, and the port P22 are sequentially connected to one another. The circuit C92 is a fluid circuit in which the port P25, the flow passage 313, the flow passage 340, the pump 312b, the flow passage 312, and the port P21 are sequentially connected to one another. In the first coupling mode, the pumps 311c and 312b are driven and these pumps circulate the heat medium through the circuits C91 and C92. The heat medium having flowed out from the port P25 to the flow passage 313 splits at the junction 341 to flow through the flow passage 340 toward each of the flow passage 311 and the flow passage 312. In the first coupling mode, the flow passage 313 and each of the flow passages 311, 312 are coupled to each other by the five-way valve 330. As each of the flow passages 311, 312 is connected to the flow passage 313 in which the reserve tank 313b is provided, air bleeding of the heat medium is performed in each of the flow passages 311, 312.

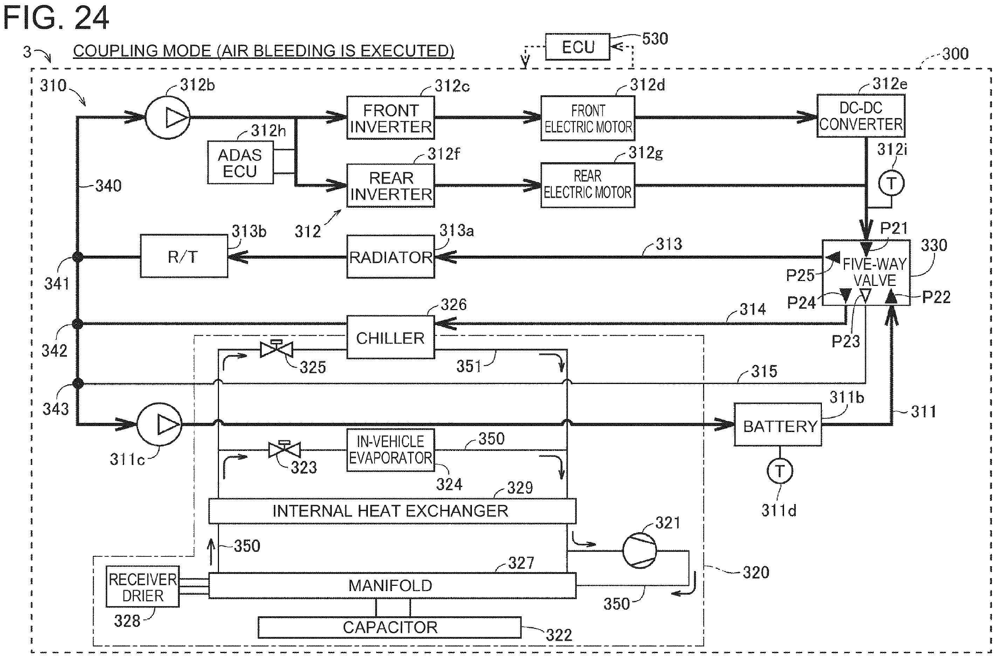

FIG. 24 is a view for describing the second coupling mode of the heat management system 3. Referring to FIG. 24, in the second coupling mode, in the five-way valve 330, the port P21 is connected to each of the ports P24, P25, and the port P22 is connected to each of the ports P24, P25. The port P23 is not connected to any other port. Also in this second coupling mode, the flow passage 313 and each of the flow passages 311, 312 are coupled to each other by the five-way valve 330. As each of the flow passages 311, 312 is connected to the flow passage 313 in which the reserve tank 313b is provided, air bleeding of the heat medium is performed in each of the flow passages 311, 312. In the second coupling mode, each of the flow passages 311, 312 is connected to the flow passage 314, too.

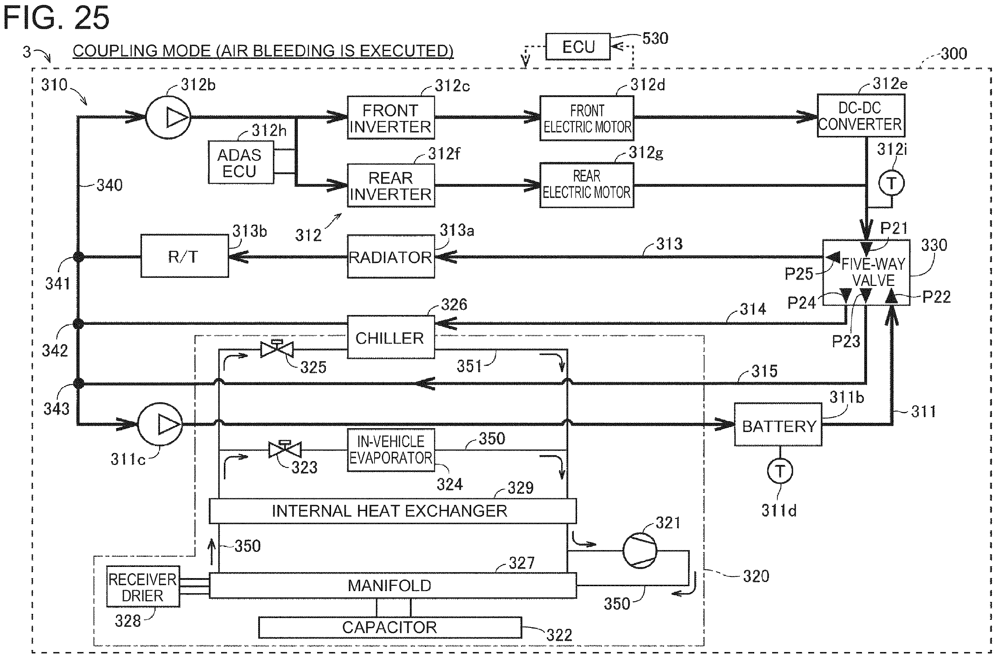

FIG. 25 is a view for describing the third coupling mode of the heat management system 3. Referring to FIG. 25, in the third coupling mode, in the five-way valve 330, the port P21 is connected to each of the ports P23 to P25 and the port P22 is connected to each of the ports P23 to P25. Also in this third coupling mode, the flow passage 313 and each of the flow passages 311, 312 are coupled to each other by the five-way valve 330. As each of the flow passages 311, 312 is connected to the flow passage 313 in which the reserve tank 313b is provided, air bleeding of the heat medium is performed in each of the flow passages 311, 312. In the third coupling mode, each of the flow passages 311, 312 is connected to the flow passages 314 and 315, too.

The ECU 530 may execute the process flow F2 shown in FIG. 15 or the process flow F2A shown in FIG. 16. In this modified example, however, instead of the modes shown in FIG. 13 and FIG. 14, the modes shown in FIG. 22 to FIG. 25 are adopted. When the coupling conditions are not met, the uncoupling mode is permitted in S50A. In S50A, the ECU 530 may switch among the uncoupling mode (FIG. 22), the first coupling mode (FIG. 23), the second coupling mode (FIG. 24), and the third coupling mode (FIG. 25) according to the state of the vehicle equipped with the heat management system 3. When the coupling conditions are met, in S53, the coupling mode is maintained and the uncoupling mode is prohibited. In S53, the ECU 530 controls the five-way valve 330 such that the heat management system 3 operates in one of the first to third coupling modes. Thus, air bleeding of the heat medium is performed in each of the flow passages 311, 312. In S53, the ECU 530 may select one coupling mode among the first to third coupling modes such that devices (targets of heat management) installed in the vehicle do not reach excessively high temperatures or excessively low temperatures. In this modified example, the five-way valve 330, the flow passages 311, 312, the flow passage 313, and the ECU 530 correspond to one example of "switching device," "first flow passage," "second flow passage," and "control device," respectively, according to this disclosure.

In an embodiment in which a bypass path that bypasses the battery 311b is provided in the heat management circuit 300, the ECU 530 may execute the process flow F1 shown in FIG. 7 or the process flow F1A shown in FIG. 10. For example, the flow passage 315 may be changed to the bypass path as the port P23 is changed from an output port to an input port.

The vehicle to which the heat management system is applied is not limited to a passenger car and may instead be a bus, a truck, or a work vehicle (a tractor, a forklift, etc.). The vehicle may be configured to be able to travel driverlessly by autonomous driving or remote driving. The vehicle may be an autonomous guided vehicle (AGV). The number of the wheels is not limited to four and may instead be three or five or more. The vehicle may be configured to be wirelessly chargeable.

The various characteristics (the characteristics described in the embodiments and the modified examples) relating to the heat management system and the heat management method described above may be implemented in arbitrary combinations. The heat management system may be applied to a device other than a vehicle.

The embodiments disclosed this time should be construed as being in every respect illustrative and not restrictive. The scope of the present invention is indicated not by the description of the embodiments given above but by the claims, and is intended to include all changes within the meaning and scope of equivalents of the claims.

## Claims

1. A heat management system (1; 1A; 2; 3), comprising:
a first flow passage in which a reserve tank (162; 265; 313b) is not provided;
a second flow passage in which a reserve tank (162; 265; 313b) is provided;
a switching device configured to switch between coupling and uncoupling of the first flow passage and the second flow passage to and from each other; and
a control device configured to control the switching device, wherein:
the control device is configured to, when predetermined coupling conditions are met, make a heat medium flow through the first flow passage and the second flow passage that have been coupled to each other by the switching device;
the control device is configured to determine whether air bubbles exceeding an allowable volume are present in the heat medium; and
when the control device determines that air bubbles exceeding the allowable volume are present in the heat medium, the coupling conditions switch from being unmet to being met.

2. The heat management system (1; 1A; 2; 3) according to claim 1, wherein the heat management system (1; 1A; 2; 3) is configured to:
when the coupling conditions are met, prohibit the switching device from uncoupling the first flow passage and the second flow passage from each other; and
when the coupling conditions are not met, permit the switching device to uncouple the first flow passage and the second flow passage from each other.

3. The heat management system (1; 1A; 2; 3) according to claim 1, further comprising a pump (131; 161; 211; 261; 311c; 312b) configured to make the heat medium flow through the first flow passage, wherein:
the control device is configured to detect overspeed rotation of the pump (131; 161; 211; 261; 311c; 312b) based on a state of the pump (131; 161; 211; 261; 311c; 312b); and
the control device is configured to determine that air bubbles exceeding the allowable volume are present in the heat medium when overspeed rotation of the pump (131; 161; 211; 261; 311c; 312b) is detected.

4. The heat management system (1; 1A; 2; 3) according to claim 1, further comprising a temperature sensor configured to detect a temperature of the heat medium, wherein the control device is configured to determine whether air bubbles exceeding the allowable volume are present in the heat medium based on whether or not a locus length of a detection value obtained by the temperature sensor is equal to or longer than a predetermined value.

5. The heat management system (1; 1A; 2; 3) according to claim 1, wherein:
the control device is configured to determine whether air bleeding of the heat medium has been completed during a period when the coupling conditions are met; and
when it is determined that the air bleeding of the heat medium has been completed, the heat management system (1; 1A; 2; 3) is configured to switch the coupling conditions from being met to being unmet.

6. The heat management system (1; 1A; 2; 3) according to claim 5, wherein the control device is configured to determine that the air bleeding of the heat medium has been completed when a predetermined time has elapsed since the coupling conditions have been met.

7. The heat management system (1; 1A; 2; 3) according to claim 5, wherein the control device is configured to determine that the air bleeding of the heat medium has been completed when it is determined that air bubbles exceeding the allowable volume are not present in the heat medium.

8. The heat management system (1; 1A; 2; 3) according to claim 1, wherein:
the heat management system (1; 1A; 2; 3) is configured to switch the coupling conditions from being met to being unmet when a predetermined time has elapsed since the coupling conditions have been met; and
the predetermined time becomes shorter as a temperature of a heating element provided in the second flow passage becomes higher.

9. The heat management system (1; 1A; 2; 3) according to claim 1, wherein the switching device includes one or more of a four-way valve, a five-way valve (180; 330), a six-way valve, a seven-way valve, an eight-way valve (280), a nine-way valve, and a ten-way valve.

10. A vehicle (10) comprising the heat management system (1; 1A; 2; 3) according to any one of claims 1 to 9.

11. The vehicle (10) according to claim 10, wherein:
the first flow passage is configured to cool a first heating element installed in the vehicle (10) by the heat medium;
the second flow passage includes a cooling path configured to cool a second heating element installed in the vehicle (10) by the heat medium, and a bypass path configured to bypass the second heating element; and
the switching device is configured to switch between the cooling path and the bypass path.

12. The vehicle (10) according to claim 11, wherein:
the second heating element includes an electricity storage device;
the first heating element includes a component configured to receive a supply of electricity from the electricity storage device; and
the control device is configured to:
when the coupling conditions are met and, moreover, a temperature of the heat medium inside the first flow passage is lower than a predetermined temperature, couple the first flow passage and the cooling path of the second flow passage to each other by the switching device and make the heat medium flow through the first flow passage and the cooling path; and
when the coupling conditions are met and, moreover, the temperature of the heat medium inside the first flow passage exceeds the predetermined temperature, couple the first flow passage and the bypass path of the second flow passage to each other by the switching device and make the heat medium flow through the first flow passage and the bypass path.
